# EUROPEAN PATENT APPLICATION

(11) **EP 4 585 723 A1**
(43) Date of publication of application: **16.07.2025**
(21) Application number: 22958173.1
(22) Date of filing: 09.09.2022
(51) Int. Cl.: C30B 11/02

(54) **CONTROL DEVICE AND PRODUCTION SYSTEM**

(71) Applicant: Kyocera Corporation, Kyoto-shi, Kyoto 612-8501 (JP)
(72) Inventor: MATSUO, Hitoshi, Kyoto-shi, Kyoto 612-8501 (JP); HACHIKI, Nobuhiko, Kyoto-shi, Kyoto 612-8501 (JP); ONITSUKA, Takeshi, Kyoto-shi, Kyoto 612-8501 (JP)
(74) Representative: TBK
(86) International application number: PCT/JP2022/033903
(87) International publication number: WO 2024/053095

(57) **Abstract**

A control device controls temperatures of heaters included in a casting furnace. The casting furnace includes a mold to receive an inorganic material and the heaters surrounding the mold to heat the mold and cause the inorganic material to melt and solidify from a bottom to manufacture an ingot. The heaters include an upper heater located above the mold, a lateral upper heater located above and lateral to the mold, and a lateral lower heater located lateral to the mold below the lateral upper heater. The control device includes a heater controller that controls, in a solidification process of the inorganic material, temperatures of the upper heater, the lateral upper heater, and the lateral lower heater based on a solidification ratio of the inorganic material and at least one of a solidification rate of the inorganic material or interface profile information indicating a solid-liquid interface profile of the inorganic material.

## Description

### TECHNICAL FIELD

The present disclosure relates to a technique for manufacturing an ingot made of an inorganic material.

### BACKGROUND OF INVENTION

Patent Literatures 1 to 4 describe techniques for manufacturing single crystals.

### CITATION LIST

### PATENT LITERATURE

Patent Literature 1: Japanese Unexamined Patent Application Publication No. 6-305877
Patent Literature 2: Japanese Unexamined Patent Application Publication No. 10-212193
Patent Literature 3: Japanese Patent No. 6969230
Patent Literature 4: WO 2020/121526

### SUMMARY

### PROBLEM TO BE SOLVED

The quality of an ingot made of an inorganic material is to be improved.

### SOLUTION TO PROBLEM

One or more aspects of the present disclosure are directed to a control device and a manufacturing system. In one embodiment, a control device controls temperatures of heaters included in a casting furnace. The casting furnace includes a mold to receive an inorganic material and the heaters surrounding the mold to heat the mold and cause the inorganic material to melt and solidify from a bottom to manufacture an ingot. The heaters include an upper heater located above the mold, a lateral upper heater located above and lateral to the mold, and a lateral lower heater located lateral to the mold below the lateral upper heater. The control device includes a heater controller that controls, in a solidification process of the inorganic material, a temperature of the upper heater, a temperature of the lateral upper heater, and a temperature of the lateral lower heater based on a solidification ratio of the inorganic material and at least one of a solidification rate of the inorganic material or interface profile information indicating a solid-liquid interface profile of the inorganic material.

In one embodiment, a manufacturing system includes a casting furnace. The casting furnace includes a mold to receive an inorganic material and heaters surrounding the mold to heat the mold and cause the inorganic material to melt and solidify from a bottom to manufacture an ingot. The manufacturing system includes the above control device that controls temperatures of the heaters included in the casting furnace.

### ADVANTAGEOUS EFFECT

The structure according to the above aspects improves the quality of an ingot made of an inorganic material.

### BRIEF DESCRIPTION OF THE DRAWINGS

FIG. 1 is a schematic diagram of an example manufacturing system.
FIG. 2 is a schematic diagram of an example casting furnace.
FIG. 3 is a schematic diagram of the example casting furnace.
FIG. 4 is a schematic diagram of heaters in an example arrangement.
FIG. 5 is a schematic diagram of a control device illustrating its example structure.
FIG. 6 is a schematic diagram of a controller included in the control device illustrating its example structure.
FIG. 7 is a table showing example explanatory variables and example response variables.
FIG. 8 is a schematic diagram describing an operation example of a first estimator.
FIG. 9 is a schematic diagram illustrating a ρb distribution virtually superimposed on a section of a silicon material.
FIG. 10 is a schematic flowchart of an operation example of the control device in a melting process.
FIG. 11 is a schematic flowchart of an operation example of the control device in a solidification process.
FIG. 12 is a schematic flowchart of an operation example of the control device in the solidification process.
FIG. 13 is a schematic flowchart of an operation example of the control device in the solidification process.
FIG. 14 is a schematic flowchart of an operation example of the control device in the solidification process.
FIG. 15 is a schematic diagram of the control device illustrating an example display.
FIG. 16 is a schematic diagram of the control device illustrating an example display.
FIG. 17 is a schematic diagram of the control device illustrating an example display.
FIG. 18 is a schematic diagram of the control device illustrating an example display.
FIG. 19 is a schematic diagram of the control device illustrating an example display.
FIG. 20 is a schematic diagram of an example table used for controlling the temperatures of the heaters.
FIG. 21 is a schematic diagram of an example table used for controlling the temperatures of the heaters.
FIG. 22 is a schematic diagram of an example table used for controlling the temperatures of the heaters.

### DESCRIPTION OF EMBODIMENTS

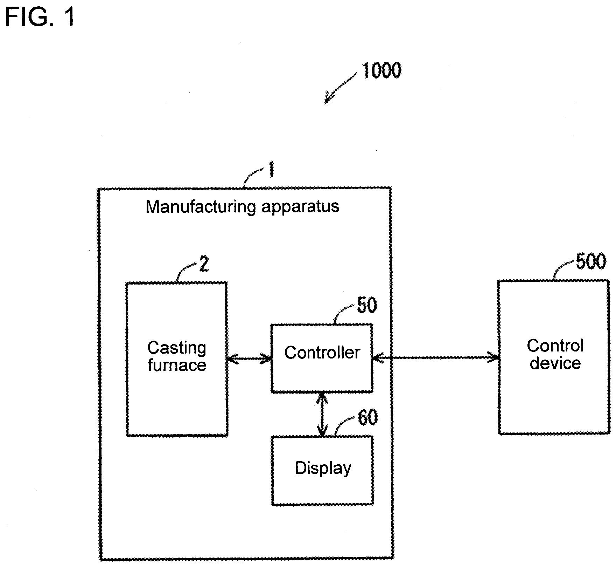

FIG. 1 is a schematic diagram of an example manufacturing system 1000 for manufacturing an inorganic ingot made of an inorganic material. As illustrated in FIG. 1, the manufacturing system 1000 includes, for example, a manufacturing apparatus 1 for manufacturing ingots and a control device 500 for controlling the manufacturing apparatus 1. The control device 500 can control the manufacturing apparatus 1.

The manufacturing apparatus 1 includes, for example, a casting furnace 2, a controller 50 that can control the casting furnace 2, and a display 60. The controller 50 is, for example, a programmable logic controller (PLC). The controller 50 includes, for example, a central processing unit (CPU), a storage (also referred to as a memory circuit) that stores, for example, programs executable by the CPU, and multiple interfaces. The storage can store, for example, programs. The multiple interfaces include an interface for transmitting and receiving signals with the control device 500 and an interface for transmitting and receiving, for example, signals with the casting furnace 2. The CPU can communicate with the control device 500 and control the casting furnace 2 through the multiple interfaces. The control device 500 can control the casting furnace 2 through the controller 50.

The display 60 is, for example, a touchscreen display, and also functions as an input unit that can receive an input from a user. The input unit can receive an input from the user. The display 60 may include, for example, a liquid crystal display or an organic electroluminescent (EL) display. The casting furnace 2 may not include the display 60. Example Structure of Casting Furnaces

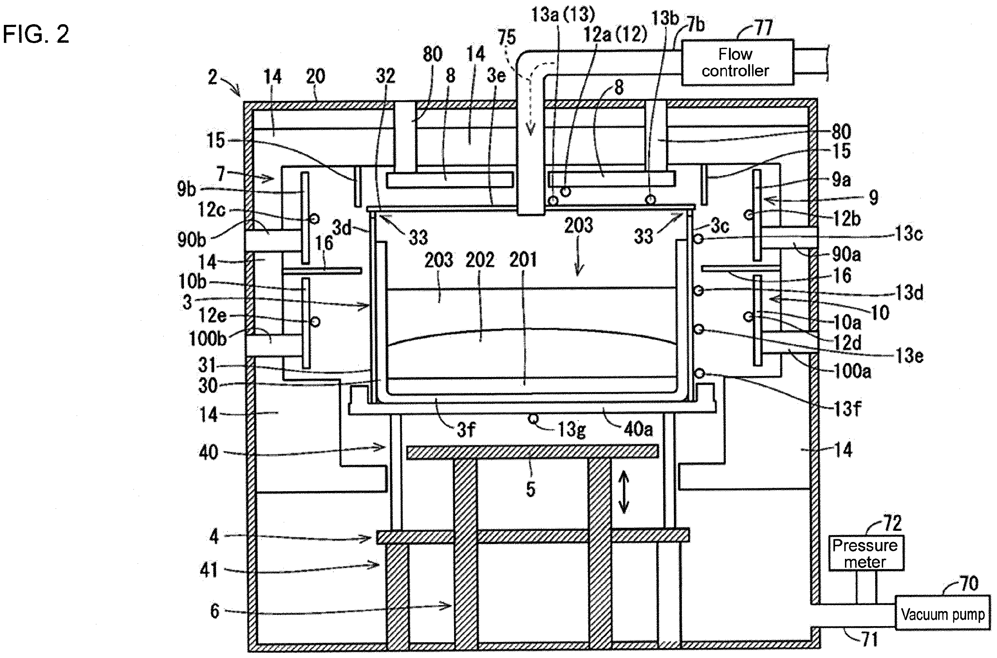

FIG. 2 is a schematic diagram of the casting furnace 2 illustrating its example structure. As illustrated in FIG. 2, the casting furnace 2 includes a housing 20, a mold 3 to receive an inorganic material 200, and heaters 7 surrounding the mold 3. The casting furnace 2 heats the mold 3 with the heaters 7 to cause the inorganic material 200 in the mold 3 to melt and then solidify from the bottom to manufacture an ingot. In other words, the casting furnace 2 uses the heaters 7 to heat the mold 3 to manufacture an ingot. The controller 50 can control the heaters 7. The mold 3 also functions as a crucible.

The inorganic material 200 may be, for example, a material made of silicon (Si) (also referred to as a silicon material). The inorganic material 200 is not limited to the silicon material, and may also be an inorganic material other than silicon. The inorganic material 200 may be, for example, a single-element semiconductor, a compound semiconductor, an oxide, an alloy, a covalent crystal, or an ionic crystal.

The single-element semiconductor may be, for example, Si, Ge, or SiC, or may be a mixed crystal of at least two selected from Si, Ge, and SiC.

The compound semiconductor may be, for example, a III-V or II-VI compound semiconductor. The III-V compound semiconductor may be, for example, GaAs, GaSb, InSb, InP, InAs, GaN, or GaP, or may be a mixed crystal of at least two selected from GaAs, GaSb, InSb, InP, InAs, GaN, and GaP. The II-VI compound semiconductor may be, for example, ZnSe, CdTe, ZnS, HgTe, or SbS, or may be a mixed crystal of at least two selected from ZnSe, CdTe, ZnS, HgTe, and SbS. The compound semiconductor may also be, for example, copper indium gallium selenide (CIGS) or copper zinc tin sulfide (CZTS).

The oxide may be, for example, ceramics. The ceramics may be, for example, Al₂O₃ (sapphire), LiTaO₃, B₂O₃, Li₂B₄O₇, or Al₂O₃/Y₃Al₅O₁₂/ZrO₂.

The alloy may be, for example, a Ag-Cu alloy, an Al-Ni alloy, an Al-Mg alloy, an Al-Si alloy, an Al-Zn alloy, a Pb-Sn alloy, a Bi-Sb alloy, or a Fe-Ni alloy, or may be a eutectic alloy of at least two selected from a Ag-Cu alloy, an Al-Ni alloy, an Al-Mg alloy, an Al-Si alloy, an Al-Zn alloy, a Pb-Sn alloy, a Bi-Sb alloy, and a Fe-Ni alloy. The alloy may also be a HgCdTe alloy.

The covalent crystal may be, for example, TaLi.

The ionic crystal may be, for example, CaF₂ (fluorite), Mg₂Si, LiF, or MgF₂, or may be a mixed crystal of at least two selected from CaF₂, Mg₂Si, LiF, and MgF₂.

The manufacturing system 1000 will be described below using the inorganic material 200 as a silicon material. The inorganic material 200 as a silicon material may be referred to as a silicon material 200.

The manufacturing apparatus 1 performs a melting process for melting the silicon material 200 in the mold 3 and a solidification process for solidifying the molten silicon material 200 from the bottom toward the top of the mold 3. The solidification process ends to complete a silicon ingot in the mold 3. The manufacturing apparatus 1 can manufacture the silicon ingot by, for example, seed casting.

Before the melting process, for example, a seed crystal 201 is placed in the mold 3. The seed crystal 201 is made of, for example, single crystal silicon. For example, a solid lump of silicon (also referred to as a silicon lump) is placed on the seed crystal 201. The silicon material 200 includes the seed crystal 201 and the silicon lump on the seed crystal 201.

In the melting process, the silicon material 200 is melted by heating the mold 3 with the heaters 7. The controller 50 can control the heaters 7 to heat the mold 3 to melt the silicon material 200. In the melting process, for example, the entire silicon lump is melted. In the melting process, the seed crystal 201 is partially melted. In other words, a part of the seed crystal 201 is melted. In the solidification process after the melting process, the control device 500 controls the temperatures of the heaters 7 to cause a silicon melt 203 contained in the silicon material 200 to solidify from the bottom toward the top. This allows, for example, manufacture of a high-quality silicon ingot with aligned crystal orientations. The controller 50 can control the temperatures of the heaters 7 to cause the silicon melt 203 contained in the silicon material 200 to solidify from the bottom toward the top. FIG. 2 illustrates the silicon material 200 during the solidification process. In the figure, the mold 3 contains a solid seed crystal 201, a solidified portion 202 being a silicon crystal on the seed crystal 201, and the silicon melt 203 on the solidified portion 202. The solidified portion 202 also includes a molten and then solidified portion of the seed crystal 201. The silicon ingot may be manufactured without using the seed crystal 201.

The casting furnace 2 includes a mold support 4 for supporting the mold 3, a cooler 5 for cooling the mold 3, and a cooler support 6 for supporting the cooler 5. The casting furnace 2 also includes multiple temperature sensors 12 (also referred to as heater temperature sensors 12) that detect the temperatures of the heaters 7, multiple temperature sensors 13 (also referred to as mold temperature sensors 13) that detect the temperature of the mold 3 (also referred to as the mold temperature), and multiple heat insulators 14, 15, and 16. The housing 20 accommodates the mold 3, the cooler 5, the heaters 7, the multiple temperature sensors 12, the multiple temperature sensors 13, and the multiple heat insulators 14, 15, and 16. At least a part of the mold support 4 and at least a part of the cooler support 6 are located inside the housing 20.

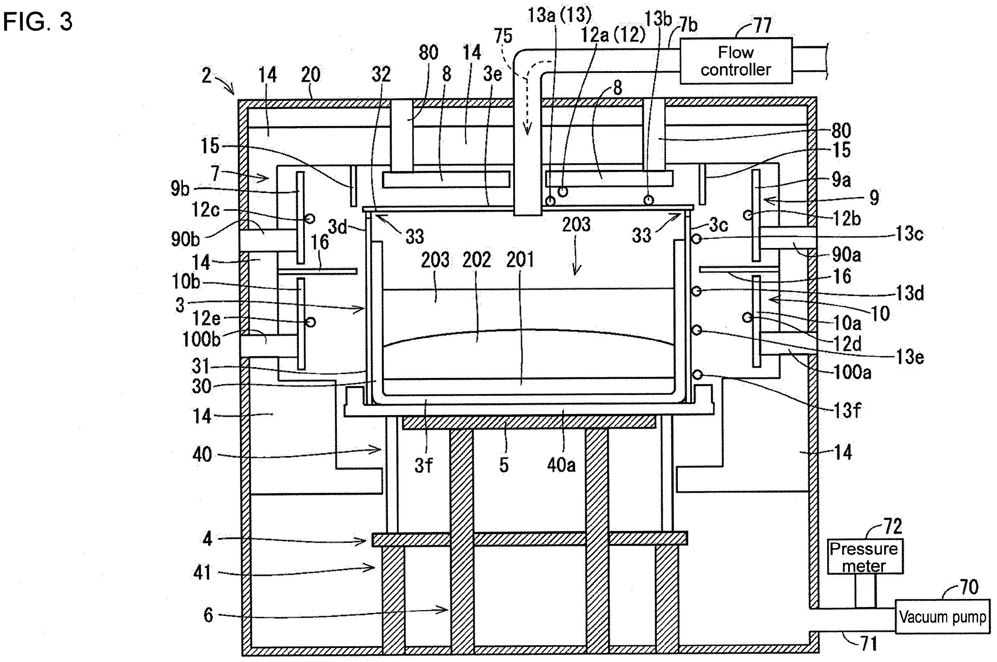

The housing 20 is made of, for example, stainless steel. The housing 20 is, for example, rectangular. The housing 20 has a door on one surface. FIG. 2 illustrates the internal structure of the housing 20 as viewed through the door. The housing 20 has, for example, a double structure, and receives supply of cooling water. The housing 20 can thus be referred to as a water-cooled housing 20. The cooling water flows throughout the housing 20. The cooling water thus flows through upper and lower portions, left and right portions, and front and rear portions of the housing 20. In FIGs. 2 and 3 (described later), hatched areas indicate the areas through which the cooling water flows in the casting furnace 2.

For the casting furnace 2, the front hereafter refers to the door surface of the housing 20 (the front side on the page of FIG. 2), and the rear hereafter refers to the side opposite to the door (the far side on the page of FIG. 2). The right hereafter refers to the right viewed from the door (the right in FIG. 2), and the left hereafter refers to the left viewed from the door (the left in FIG. 2).

The mold 3 includes, for example, an inner mold 30, an outer mold 31 outside the inner mold 30, and a lid 32. The silicon material 200 is placed in the inner mold 30. The inner mold 30 is made of, for example, silica. The inner mold 30 made of silica is replaceable, for example, every upon manufacture of a silicon ingot. The outer mold 31 and the lid 32 are made of, for example, graphite. The inner mold 30 is, for example, rectangular and has an opening in the upper surface. The outer mold 31 is, for example, rectangular and has openings in the upper and the lower surfaces. The lid 32 covers the upper openings of the inner mold 30 and the outer mold 31. The outer mold 31 has side walls higher than the side walls of the inner mold 30. The lid 32 is fixed to the upper ends of the side walls of the outer mold 31.

The mold support 4 has an upper support 40 and a lower support 41. The upper support 40 can support the mold 3. The lower support 41 can support the upper support 40. The upper support 40 is made of, for example, graphite. The lower support 41 is made of, for example, stainless steel. The upper support 40 includes a base plate 40a to receive the mold 3. The inner mold 30 and the outer mold 31 are placed on the base plate 40a. The upper support 40 can support a bottom wall 3f of the mold 3. The bottom wall may also be the bottom. The lower support 41 is, for example, hollow and receives cooling water in the same manner as the housing 20. The lower support 41 may also be a water cooling support.

The cooler 5 is, for example, a plate. The cooler 5 may also be a cooling plate 5. The cooler 5 is made of, for example, stainless steel. The cooler 5 is, for example, water-cooled. The cooler 5 is, for example, hollow and receives the cooling water. The cooler 5 is movable, for example, vertically. The cooler 5 moves upward and comes in contact with the base plate 40a in the mold support 4 to cool the mold 3. FIG. 3 is a schematic diagram illustrating an example of the cooler 5 in contact with the base plate 40a.

The cooler support 6 is made of, for example, stainless steel. The cooler support 6 is, for example, hollow and receives cooling water. The cooler support 6 may also be a water cooling support. The cooler support 6 is movable, for example, vertically by a motor. The cooler 5 is movable vertically by moving the cooler support 6 vertically. The vertical movement of the cooler support 6 and the cooler 5 is controlled by the control device 500. The control device 500 can control the vertical movement of the cooler support 6 and the cooler 5. The mold support 4 may be movable vertically. In this case, the mold 3 can move vertically.

The manufacturing apparatus 1 includes a cooling tower for supplying cooling water to the casting furnace 2. The water from the cooling tower to the casting furnace 2 is supplied to the housing 20, the cooler 5, the cooler support 6, and the lower support 41 in the mold support 4, and then returns from the casting furnace 2 to the cooling tower. The cooling tower can cool the returned water again and supply the cooled water to the casting furnace 2.

The heaters 7 include, for example, an upper heater 8 located above the mold 3, lateral upper heaters 9 located above and lateral to the mold 3, and lateral lower heaters 10 located lateral to the mold 3 below the lateral upper heaters 9. The upper heater 8 heats the mold 3 from above. The lateral upper heaters 9 and the lateral lower heaters 10 heat the mold 3 laterally. The upper heater 8, the lateral upper heaters 9, and the lateral lower heaters 10 are, for example, thermal resistance heaters.

The upper heater 8 is, for example, located to face a most part of an upper wall 3e (in other words, an upper portion 3e) of the mold 3. The upper wall 3e includes, for example, the lid 32. The upper heater 8 is located to curve along the upper wall 3e. The upper heater 8 is held by a retainer 80 fixed to the housing 20. The upper heater 8 is, for example, located to face an outer upper surface of the mold 3.

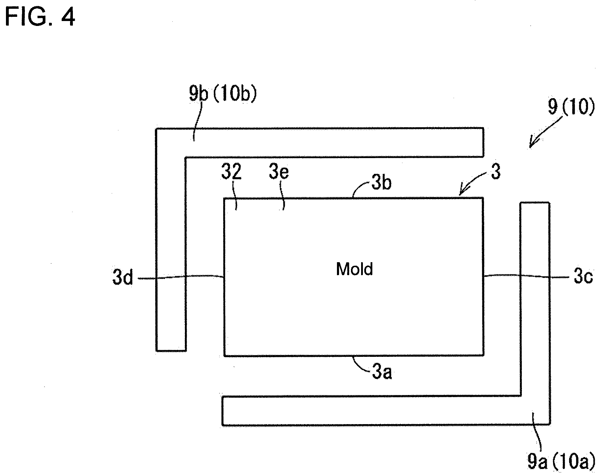

FIG. 4 is a schematic diagram of the mold 3, the lateral upper heaters 9, and the lateral lower heaters 10, as viewed from above, illustrating an example structure and simplified from FIG. 2. The lateral upper heaters 9 include a lateral upper heater 9a (also referred to as a first lateral upper heater 9a) facing a front side wall 3a and a right side wall 3c of the mold 3, and a lateral upper heater 9b (also referred to as a second lateral upper heater 9b) facing a rear side wall 3b and a left side wall 3d of the mold 3. The side walls may also be side portions. The lateral upper heater 9a faces the front outer side surface of the mold 3 and the right outer side surface of the mold 3. The lateral upper heater 9b faces the rear outer side surface of the mold 3 and the left outer side surface of the mold 3. The first lateral upper heater 9a is held by a retainer 90a fixed to the housing 20. The second lateral upper heater 9b is held by a retainer 90b fixed to the housing 20.

The first lateral upper heater 9a is, for example, located to bend along the front side wall 3a and the right side wall 3c of the mold 3. The first lateral upper heater 9a faces, for example, an upper one-third of the side wall 3a of the mold 3 and also faces an upper one-third of the side wall 3c of the mold 3. The first lateral upper heater 9a can mainly heat the upper one-third of the side wall 3a of the mold 3 and the upper one-third of the side wall 3c of the mold 3.

The second lateral upper heater 9b is, for example, located to bend along the rear side wall 3b and the left side wall 3d of the mold 3. The second lateral upper heater 9b faces, for example, an upper one-third of the side wall 3b of the mold 3 and also faces an upper one-third of the side wall 3d of the mold 3. The second lateral upper heater 9b can mainly heat the upper one-third of the side wall 3b of the mold 3 and the upper one-third of the side wall 3d of the mold 3.

The lateral lower heaters 10 include a lateral lower heater 10a (also referred to as a first lateral lower heater 10a) facing the front side wall 3a and the right side wall 3c of the mold 3, and a lateral lower heater 10b (also referred to as a second lateral lower heater 10b) facing the rear side wall 3b and the left side wall 3d of the mold 3. The lateral lower heater 10a faces the front outer side surface of the mold 3 and the right outer side surface of the mold 3. The lateral lower heater 10b faces the rear outer side surface of the mold 3 and the left outer side surface of the mold 3. The first lateral lower heater 10a is held by a retainer 100a fixed to the housing 20. The second lateral lower heater 10b is held by a retainer 100b fixed to the housing 20.

The first lateral lower heater 10a is, for example, located to bend along the front side wall 3a and the right side wall 3c of the mold 3. The first lateral lower heater 10a faces, for example, lower two-thirds of the side wall 3a of the mold 3 and also faces lower two-thirds of the side wall 3c of the mold 3. The first lateral lower heater 10a can mainly heat the lower two-thirds of the side wall 3a of the mold 3 and the lower two-thirds of the side wall 3c of the mold 3.

The second lateral lower heater 10b is, for example, located to bend along the rear side wall 3b and the left side wall 3d of the mold 3. The second lateral lower heater 10b faces, for example, lower two-thirds of the rear side wall 3b of the mold 3 and also faces lower two-thirds of the left side wall 3d of the mold 3. The second lateral lower heater 10b can mainly heat the lower two-thirds of the side wall 3b of the mold 3 and the lower two-thirds of the side wall 3d of the mold 3.

The upper heater 8 can mainly heat the upper wall 3e. The lateral upper heaters 9 can mainly heat the upper one-third of the side walls of the mold 3. The lateral lower heaters 10 can mainly heat the lower two-thirds of the side walls of the mold 3.

The first lateral upper heater 9a and the second lateral upper heater 9b are located, for example, above the upper surface of the silicon material 200 in the mold 3 in the solidification process. In other words, the first lateral upper heater 9a and the second lateral upper heater 9b are located, for example, above the upper surface of the silicon melt 203 in the mold 3 in the solidification process.

The first lateral lower heater 10a and the second lateral lower heater 10b are located lateral to the silicon material 200 in the mold 3 in the solidification process. The first lateral lower heater 10a and the second lateral lower heater 10b may be located, for example, upward from the upper surface of the seed crystal 201 in the mold 3 in the solidification process. The lateral lower heaters 10 mainly heat lateral portions of the silicon material 200 in the mold 3 in the solidification process. The temperatures of the upper heater 8, the first lateral upper heater 9a, the second lateral upper heater 9b, the first lateral lower heater 10a, and the second lateral lower heater 10b are controlled by the control device 500. The control device 500 can control the temperatures of the upper heater 8, the first lateral upper heater 9a, the second lateral upper heater 9b, the first lateral lower heater 10a, and the second lateral lower heater 10b.

The first lateral upper heater 9a and the second lateral upper heater 9b may be connected to each other to serve as a single heater. The first lateral lower heater 10a and the second lateral lower heater 10b may be connected to each other to serve as a single heater. The locations of the upper heater 8, the lateral upper heaters 9, and the lateral lower heaters 10 are not limited to the above example.

The multiple heater temperature sensors 12 include, for example, heater temperature sensors 12a, 12b, 12c, 12d, and 12e that detect the respective temperatures of the upper heater 8, the first lateral upper heater 9a, the second lateral upper heater 9b, the first lateral lower heater 10a, and the second lateral lower heater 10b. The respective heater temperature sensors 12a, 12b, 12c, 12d, and 12e are located in the upper heater 8, the first lateral upper heater 9a, the second lateral upper heater 9b, the first lateral lower heater 10a, and the second lateral lower heater 10b. The temperature sensors 12a, 12b, 12c, 12d, and 12e may be, for example, thermocouples. The controller 50 inputs the detection results from the temperature sensors 12a, 12b, 12c, 12d, and 12e into the control device 500.

The upper heater 8, the first lateral upper heater 9a, the second lateral upper heater 9b, the first lateral lower heater 10a, and the second lateral lower heater 10b may be hereafter simply referred to as heaters without being distinguished from one another. The temperature sensor 12 corresponding to the heater refers to the temperature sensor 12 that detects the temperature of the heater.

The detection results from the multiple mold temperature sensors 13 are used for, for example, controlling the temperatures of the heaters 7 in the solidification process. The multiple mold temperature sensors 13 include, for example, two mold temperature sensors 13a and 13b that detect the temperature of the upper wall 3e of the mold 3 (in other words, the temperature of the lid 32). The multiple mold temperature sensors 13 include multiple mold temperature sensors 13c, 13d, 13e, and 13f that detect the temperatures of the side walls of the mold 3. The multiple mold temperature sensors 13 include a mold temperature sensor 13g that detects the temperature of the bottom wall 3f of the mold 3. The mold temperature sensors 13a, 13b, 13c, 13d, 13e, 13f, and 13g are, for example, thermocouples. The controller 50 can input the detection results from the mold temperature sensors 13a, 13b, 13c, 13d, 13e, 13f, and 13g into the control device 500.

The mold temperature sensor 13g is located on, for example, the base plate 40a supporting the bottom wall 3f of the mold 3. The mold temperature sensor 13g can detect the temperature of the base plate 40a as the temperature of the bottom wall 3f of the mold 3.

The mold temperature sensors 13a and 13b can detect the temperature of the upper wall 3e of the mold 3 mainly heated by the upper heater 8. The mold temperature sensor 13a can detect the temperature at the center of the upper wall 3e of the mold 3. The mold temperature sensor 13a is located on, for example, the outer surface at the center of the upper wall 3e of the mold 3. The mold temperature sensor 13a can detect the temperature of the outer surface at the center of the upper wall 3e. The mold temperature sensor 13b can detect the temperature at a peripheral end (also referred to as an end) of the upper wall 3e (in other words, the lid 32) of the mold 3. The mold temperature sensor 13b is located on, for example, the outer surface at the peripheral end of the upper wall 3e of the mold 3. The mold temperature sensor 13b can detect the temperature of the outer surface at the peripheral end of the upper wall 3e.

The mold temperature sensor 13c can detect the temperature of a portion of the mold 3 mainly heated by the lateral upper heaters 9. For example, the mold temperature sensor 13c can detect the temperature of the upper one-third of a side wall of the mold 3. The mold temperature sensor 13c is located on, for example, the outer surface of the upper one-third of the side wall 3c. The mold temperature sensor 13c can detect the temperature of the outer surface of the upper one-third of the side wall 3c.

The mold temperature sensors 13d, 13e, and 13f can detect the temperatures of portions of the mold 3 mainly heated by the lateral lower heaters 10. For example, the mold temperature sensors 13d, 13e, and 13f can detect the temperatures of the lower two-thirds of a side wall of the mold 3. The mold temperature sensors 13d, 13e, and 13f can detect, for example, the temperatures of the lower two-thirds of the right side wall 3c of the mold 3. The mold temperature sensors 13d, 13e, and 13f are located on, for example, the outer surface of the lower two-thirds of the side wall 3c. The mold temperature sensors 13d, 13e, and 13f can detect the temperatures of the outer surface of the lower two-thirds of the side wall 3c. The mold temperature sensors 13d, 13e, and 13f are arranged, for example, at equal intervals vertically on the outer surface of the side wall of the mold 3.

The mold temperature sensors 13d, 13e, and 13f are at positions corresponding to the height of the silicon material 200 in the mold 3 in the solidification process. The upper end of the silicon material 200 in the mold 3 in the solidification process is referred to as an upper end of the silicon material. In the solidification process, a middle portion of the silicon material 200 in the vertical direction in the mold 3 is referred to as a middle portion of the silicon material. The lower end of the silicon material 200 in the mold 3 in the solidification process is referred to as a lower end of the silicon material.

The mold temperature sensor 13d can detect the temperature of a portion of a side wall of the mold 3 lateral to the upper end of the silicon material. For example, the mold temperature sensor 13d can detect the temperature of a portion of the right side wall 3c of the mold 3 lateral to the upper end of the silicon material. The mold temperature sensor 13d is located on, for example, an outer surface of the portion of the side wall 3c of the mold 3 lateral to the upper end of the silicon material.

The mold temperature sensor 13e can detect the temperature of a portion of a side wall of the mold 3 lateral to the middle portion of the silicon material. For example, the mold temperature sensor 13e can detect the temperature of a portion of the right side wall 3c of the mold 3 lateral to the middle portion of the silicon material. The mold temperature sensor 13e is located on, for example, the outer surface of the portion of the side wall 3c of the mold 3 lateral to the middle portion of the silicon material.

The mold temperature sensor 13f can detect the temperature of a portion of a side wall of the mold 3 lateral to the lower end of the silicon material. For example, the mold temperature sensor 13f can detect the temperature of a portion of the right side wall 3c of the mold 3 lateral to the lower end of the silicon material. The mold temperature sensor 13f is located on, for example, the outer surface of the portion of the side wall 3c of the mold 3 lateral to the lower end of the silicon material.

At least one of the mold temperature sensors 13c, 13d, 13e, and 13f may be mounted on the left side wall 3d of the mold 3, on the front side wall 3a of the mold 3, or on the rear side wall 3b of the mold 3.

The heat insulator 14 is made of, for example, carbon. The heat insulator 14 laterally surrounds the mold 3 and extends along the inner surfaces of the housing 20 to cover the top of the mold 3.

The heat insulator 15 is made of, for example, carbon felt. The heat insulator 16 is made of, for example, carbon felt. The heat insulator 15 is located, for example, to hide one of the upper heater 8 or the lateral upper heaters 9 as viewed from the other of the upper heater 8 or the lateral upper heaters 9. The heat insulator 15 is, for example, annular to laterally surround the upper heater 8. The heat insulator 16 is located, for example, to hide one of the lateral upper heaters 9 or the lateral lower heaters 10 as viewed from the other of the lateral upper heaters 9 or the lateral lower heaters 10. The heat insulator 16 is, for example, annular to laterally surround the mold 3 and is between the lateral upper heaters 9 and the lateral lower heaters 10.

The heat insulator 15 reduces heat transfer from the lateral upper heaters 9 to the upper wall 3e. The temperatures detected by the mold temperature sensors 13a and 13b are thus less likely to be affected by any heater other than the upper heater 8. The detection results from the mold temperature sensors 13a and 13b indicate the effect of heat from the upper heater 8 on the mold 3.

The heat insulator 15 reduces heat transfer from the upper heater 8 to the portions of the mold 3 mainly heated by the lateral upper heaters 9, or more specifically, the upper one-third of the side walls of the mold 3. The heat insulator 16 reduces heat transfer from the lateral lower heaters 10 to the portion of the mold 3 mainly heated by the lateral upper heaters 9. The temperature detected by the mold temperature sensor 13c is thus less likely to be affected by any heater other than the lateral upper heaters 9. The detection result from the mold temperature sensor 13c indicates the effect of heat from the lateral upper heaters 9 on the mold 3.

The heat insulator 16 reduces heat transfer from the lateral upper heaters 9 to the portions of the mold 3 mainly heated by the lateral lower heaters 10, or more specifically, the lower two-thirds of the side walls of the mold 3. The temperatures detected by the mold temperature sensors 13d, 13e, and 13f are thus less likely to be affected by any heater other than the lateral lower heaters 10. The detection results from the mold temperature sensors 13d, 13e, and 13f indicate the effect of heat from the lateral lower heaters 10 on the mold 3.

The heat insulator 15 reduces the likelihood that the mold temperature sensors 13a and 13b detect heat from the lateral upper heaters 9 and also reduces the likelihood that the mold temperature sensor 13c detects heat from the upper heater 8. The heat insulator 16 reduces the likelihood that the mold temperature sensor 13c detects heat from the lateral lower heaters 10 and also reduces the likelihood that the mold temperature sensors 13d, 13e, and 13f detect heat from the lateral upper heaters 9.

The manufacturing apparatus 1 includes a vacuum pump 70 to evacuate the housing 20 and create a vacuum inside during manufacture of a silicon ingot. A pipe 71 extends from the vacuum pump 70 and is connected with a space inside the housing 20. The manufacturing apparatus 1 also includes a pressure meter 72 that can measure a pressure value in the housing 20. When the inside of the housing 20 is a vacuum, the pressure meter 72 can measure a vacuum pressure value in the housing 20. The controller 50 can input the pressure value measured by the pressure meter 72 into the control device 500.

During manufacture of a silicon ingot, an inert gas 75 is supplied into the mold 3. The inert gas 75 is, for example, an argon gas. The space in the mold 3 connects with a pipe 76 through which the inert gas 75 flows. The manufacturing apparatus 1 also includes a flow controller 77 that controls the flow rate of the inert gas 75 supplied into the mold 3. The flow controller 77 includes a flowmeter that can measure the flow rate of the inert gas 75 (more specifically, the flow rate of the inert gas 75 in the pipe 76). The controller 50 can input the measured flow rate obtained by the flowmeter into the control device 500.

The mold 3 has a clearance 33 between the upper end of the outer mold 31 and the lid 32. Impurity gases generated in the mold 3 during manufacture of a silicon ingot and the inert gas 75 supplied into the mold 3 are discharged out of the mold 3 through the clearance 33, and further discharged out of the housing 20 as the vacuum pump 70 operates. The control device 500 can control the vacuum pump 70 and the flow controller 77 through the controller 50.

### Example Structure of Control Device

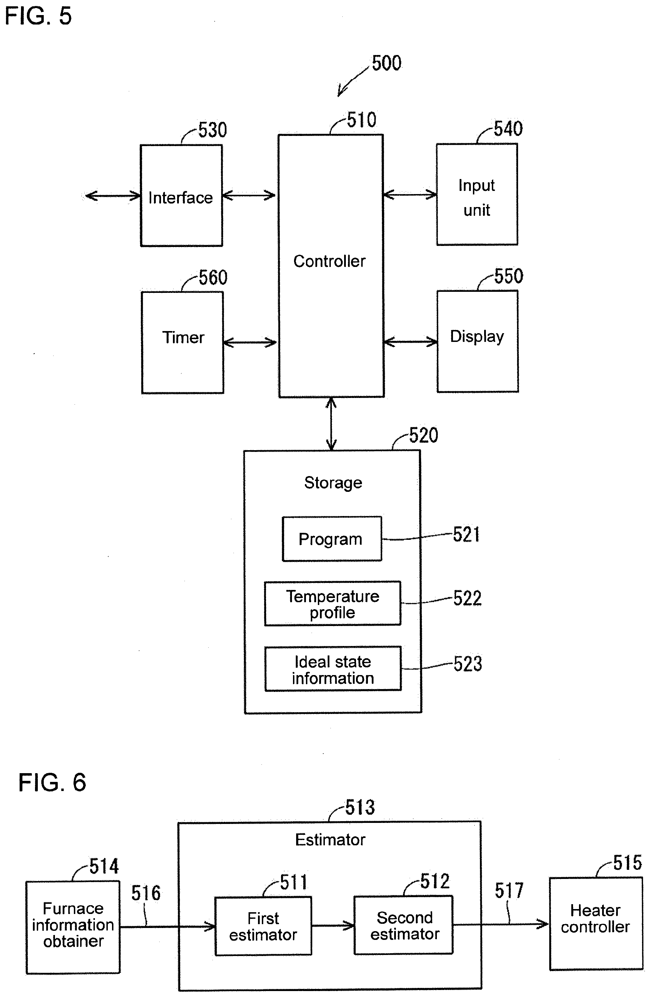

FIG. 5 is a schematic diagram of the control device 500 illustrating its example structure. As illustrated in FIG. 5, the control device 500 includes, for example, a controller 510, a storage 520, an interface 530, an input unit 540, a display 550, and a timer 560. The control device 500 may be, for example, a control circuit. The control device 500 is, for example, a computer device. The control device 500 may be, for example, a desktop or a laptop personal computer, a tablet terminal, a mobile phone such as a smartphone, or any other device. The control device 500 may also be a cloud server. The cloud server may include at least one server.

The interface 530 can communicate with an interface included in the controller 50 in the manufacturing apparatus 1 in accordance with a predetermined communication protocol. The interface 530 may be, for example, an interface circuit. The interface 530 may be, for example, a communication unit or a communication circuit. The interface 530 may allow wired communication or wireless communication with the controller 50. The interface 530 can receive information transmitted from the controller 50 and allow an input of the received information into the controller 510. The information transmitted by the controller 50 includes, for example, at least one of the detection results from the heater temperature sensors 12a, 12b, 12c, 12d, and 12e, the detection results from the mold temperature sensors 13a, 13b, 13c, 13d, 13e, 13f, and 13g, the measured flow rate obtained by the flow controller 77, or the measured pressure value obtained by the pressure meter 72. The interface 530 can also transmit information from the controller 510 to the controller 50. The information transmitted from the control device 500 to the controller 50 includes, for example, at least one of control information for controlling the temperatures of the upper heater 8, the lateral upper heaters 9, and the lateral lower heaters 10, control information for controlling the flow controller 77, control information for controlling the vacuum pump 70, or control information for controlling the vertical position of the cooler 5.

The controller 510 can control the other components of the control device 500 to centrally manage the operation of the control device 500. The controller 510 may be, for example, a control circuit. As described in more detail below, the controller 510 includes at least one processor to provide control and processing capabilities for implementing various functions.

In various embodiments, at least one processor may be implemented as a single integrated circuit (IC), multiple ICs connected to one another for mutual communication, discrete circuits, or both the ICs and discrete circuits. The processor can be implemented with various known techniques.

In one embodiment, for example, the processor includes one or more circuits or units that execute instructions stored in an associated memory to perform one or more data computation procedures or processes. In another embodiment, the processor may be firmware (e.g., a discrete logic component) that performs one or more data computation procedures or processes.

In various embodiments, the processor includes one or more processors, controllers, microprocessors, microcontrollers, application-specific integrated circuits (ASICs), digital signal processors, programmable logic devices, field programmable gate arrays, combinations of any of these devices or configurations, or combinations of other known devices and configurations, and may implement the functions described below.

The controller 510 may include, for example, a CPU as a processor. The storage 520 may include a non-transitory recording medium readable by the CPU in the controller 510, such as a read-only memory (ROM) or a random-access memory (RAM). The storage 520 can store various items of information. The storage 520 stores, for example, at least one program 521 for controlling the control device 500. Various functions of the controller 510 are implemented by, for example, the CPU in the controller 510 executing the program 521 in the storage 520. The storage 520 also stores, for example, a temperature profile 522 and ideal state information 523, which will be described later. The controller 510 can write information into the storage 520. More specifically, the controller 510 can control the storage 520 to store information.

The configuration of the controller 510 is not limited to the above example. For example, the controller 510 may include multiple CPUs. The controller 510 may also include at least one digital signal processor (DSP). The functions of the controller 510 may be implemented entirely or partially using hardware circuits, without using software to implement the functions. The storage 520 may also include a non-transitory computerreadable recording medium other than a ROM and a RAM. The storage 520 may include, for example, a small hard disk drive and a solid-state drive (SSD). The controller 50 in the manufacturing apparatus 1 may have the same structure as the controller 510. The storage included in the controller 50 may have the same structure as the storage 520.

The input unit 540 can receive inputs from the user. The input unit 540 may include, for example, a mouse and a keyboard. The input unit 540 may include a touch sensor that can receive a touch operation performed by the user. The input unit 540 may include a microphone to receive a voice input from the user. The controller 510 can obtain the details of the user input received by the input unit 540 based on an output signal from the input unit 540.

The display 550 can display various items of information under control by the controller 510. The controller 510 can control the display 550 to display various items of information. The display 550 may be, for example, a liquid crystal display or an organic EL display. For the input unit 540 including the touch sensor, the touch sensor and the display 550 may be included in a touchscreen display with display and touch detection functions. The touchscreen display can detect a touch operation on the display surface of the display 550. The input unit 540 and the display 550 together serve as a user interface.

The timer 560 can measure time. The timer 560 may be, for example, a timer circuit, a time measuring unit, or a time measuring circuit. The timer 560 can input the time measurement results into the controller 510.

### Example Function of Controller in Control Device

FIG. 6 is a schematic diagram of the controller 510 for controlling the heaters 7 in the solidification process, illustrating example functional blocks. The controller 510 includes, for example, an estimator 513, a furnace information obtainer 514, and a heater controller 515 as functional blocks. The CPU in the controller 510 executes the program 521 in the storage 520 to implement the estimator 513, the furnace information obtainer 514, and the heater controller 515 in the controller 510. The functions of the estimator 513 may be implemented entirely or partially using hardware circuits, without using software to implement the functions. The same applies to the furnace information obtainer 514 and the heater controller 515.

The furnace information obtainer 514 can obtain furnace information 516 indicating the state of the casting furnace 2 at every elapsed time (in other words, at every elapsed time point) from the start of the solidification process and output the information to the estimator 513. For example, the furnace information obtainer 514 obtains and outputs the furnace information 516 indicating the state of the casting furnace 2 at the elapsed time (in other words, at the elapsed time point) at an elapse of every minute in the solidification process. As described later, the furnace information 516 includes the elapsed time from the start of the solidification process and information indicating the state of the casting furnace 2 at the elapsed time. The elapsed time hereafter simply refers to the time elapsed from the start of the solidification process.

The estimator 513 can estimate the state of the silicon material 200 in the solidification process based on the furnace information 516. The estimator 513 can estimate, based on the furnace information 516, the state information 517 indicating the state of the silicon material 200 at the elapsed time included in the furnace information 516. The estimator 513 receives the furnace information 516 at every predetermined elapsed time (e.g., one minute). Thus, the estimator 513 can estimate the state information 517 indicating the state of the silicon material 200 at every elapsed time.

In the solidification process, the furnace information obtainer 514 obtains the furnace information 516 including, for example, M (M is an integer greater than or equal to 2) pieces of furnace information 516. More specifically, the furnace information obtainer 514 estimates the state of the casting furnace 2 at M elapsed time points from the start of the solidification process. In the solidification process, the estimator 513 thus estimates the state information 517 M times. When the furnace information obtainer 514 obtains the furnace information 516 indicating the state of the casting furnace 2 at an elapsed time of every minute in the solidification process, the value of M is, for example, several thousands. The elapsed time included in the furnace information 516 may be hereafter referred to as an estimation elapsed time. The M estimation elapsed times included in each of the M pieces of furnace information 516 obtained in the solidification process may be collectively referred to as an estimation elapsed time set.

The heater controller 515 can control the temperatures of the heaters 7 based on the estimated state information 517 in the solidification process. The heater controller 515 can also control the temperatures of the heaters 7 in the melting process.

The estimator 513 includes a first estimator 511 and a second estimator 512. The first estimator 511 can estimate, based on the furnace information 516, the liquid phase ratio of the silicon material 200 in the estimation elapsed time included in the furnace information 516. In the solidification process, the first estimator 511 estimates the liquid phase ratio of the silicon material 200 M times.

The second estimator 512 can estimate the state information 517 in the estimation elapsed time based on the liquid phase ratio estimated by the first estimator 511 in the estimation elapsed time. The state information 517 includes, for example, at least one of the solidification ratio of the silicon material 200, the solidification rate of the silicon material 200, or interface profile information about the solid-liquid interface profile of the silicon material 200.

The liquid phase ratio refers to the ratio of the amount of the liquid portion contained in the silicon material 200 to the total amount of the silicon material 200. In other words, the liquid phase ratio refers to the ratio of the amount of the silicon melt 203 contained in the silicon material 200 to the total amount of the silicon material 200. The solidification ratio refers to the ratio of the amount of the solid portion contained in the silicon material 200 to the total amount of the silicon material 200. When the seed crystal 201 is used, as in this example, the solid portion contained in the silicon material 200 includes the solid seed crystal 201 and the solidified portion 202. When the seed crystal 201 is not used, the solid portion contained in the silicon material 200 includes the solidified portion 202 alone. The liquid phase ratio and the solidification ratio are both expressed in, for example, %.

### Operation Example of First Estimator and Furnace Information Obtainer

The first estimator 511 can estimate the liquid phase ratio using, for example, supervised machine learning. The first estimator 511 may use, for example, a random forest, as a method for machine learning. The first estimator 511 can estimate the liquid phase ratio based on the furnace information 516 using pre-learned parameters. The learned parameters are stored into the storage 520.

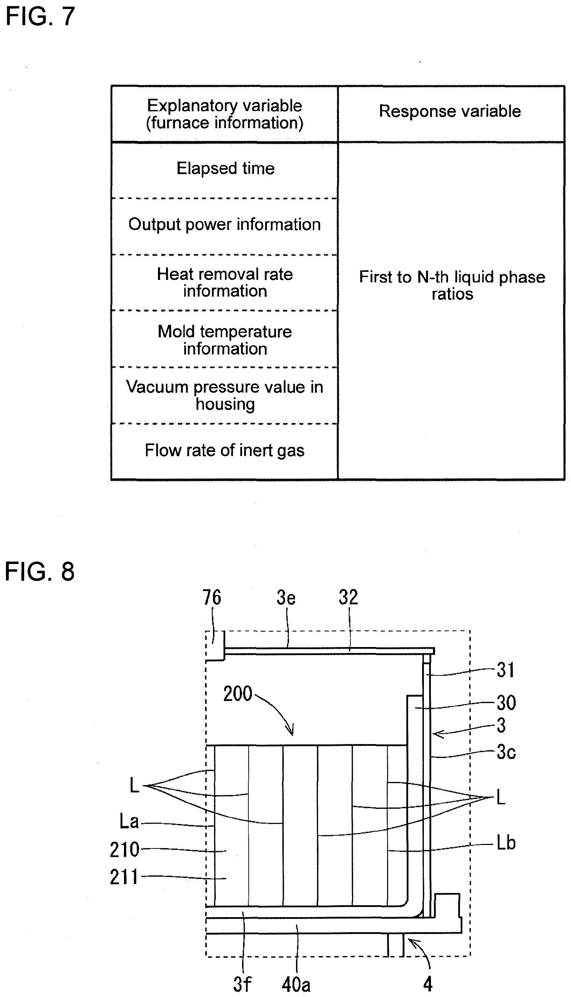

FIG. 7 is a table showing example explanatory variables and example response variables used by the first estimator 511. The explanatory variables may be included in the furnace information 516 input into the first estimator 511. The response variables may be included in output information from the first estimator 511.

The explanatory variables (in other words, the furnace information 516) include, for example, at least one of the elapsed time (in other words, the estimation elapsed time), the output power information about the heaters 7 at the elapsed time, the heat removal rate information about the cooling function of the casting furnace 2 at the elapsed time, the mold temperature information at the elapsed time, the vacuum pressure value in the housing 20 at the elapsed time, or the flow rate of the inert gas 75 at the elapsed time.

The elapsed time is measured by, for example, the timer 560. The furnace information obtainer 514 obtains the elapsed time from the timer 560.

The output power information includes, for example, at least one of the output power values from the upper heater 8, the first lateral upper heater 9a, the second lateral upper heater 9b, the first lateral lower heater 10a, and the second lateral lower heater 10b. In the solidification process, the output power information affects the liquid phase ratio of the silicon material 200.

The casting furnace 2 includes, for example, multiple output meters that can measure the output power values from the upper heater 8, the first lateral upper heater 9a, the second lateral upper heater 9b, the first lateral lower heater 10a, and the second lateral lower heater 10b. The output power values measured by the respective output meters are input into the controller 50. The furnace information obtainer 514 can request the controller 50 to transmit the output power value through the interface 530 at every predetermined elapsed time. The controller 50 can transmit, as requested from the control device 500, the output power values measured by each output meter to the control device 500. This allows the furnace information obtainer 514 to obtain the output power information at every predetermined elapsed time.

The heat removal rate information includes, for example, the heat removal rate of the cooler 5 and the heat removal rate of the water-cooled housing 20. In the solidification process, the heat removal rate information affects the liquid phase ratio of the silicon material 200. The casting furnace 2 includes a first temperature sensor that can detect the water temperature at the inlet of the cooler 5, and a second temperature sensor that can detect the water temperature at the outlet of the cooler 5. The casting furnace 2 also includes a third temperature sensor that can detect the water temperature at the inlet of the water-cooled housing 20, and a fourth temperature sensor that can detect the water temperature at the outlet of the water-cooled housing 20. At least one of the first temperature sensor, the second temperature sensor, the third temperature sensor, or the fourth temperature sensor allows inputs of the detection results into the controller 50.

The furnace information obtainer 514 can request the controller 50 to transmit the detection results from the first, second, third, and fourth temperature sensors through the interface 530 at every predetermined elapsed time. The controller 50 can transmit the detection results from the first, second, third, and fourth temperature sensors to the control device 500 as requested from the control device 500. The furnace information obtainer 514 can determine, based on the detection results from the first and second temperature sensors, a first temperature difference between the water temperature at the outlet of the cooler 5 and the water temperature at the inlet of the cooler 5. The furnace information obtainer 514 can determine the heat removal rate of the cooler 5 based on the first temperature difference and the water flow rate in the cooler 5. The furnace information obtainer 514 can determine, based on the detection results from the third and fourth temperature sensors, a second temperature difference between the water temperature at the outlet of the water-cooled housing 20 and the water temperature at the inlet of the water-cooled housing 20. The furnace information obtainer 514 can determine the heat removal rate in the water-cooled housing 20 based on the second temperature difference and the water flow rate in the water-cooled housing 20. This allows the furnace information obtainer 514 to obtain the heat removal rate information at every predetermined elapsed time. The water flow rate in the cooler 5 and the water flow rate in the water-cooled housing 20 are, for example, the same fixed value. The storage 520 prestores this fixed value of the flow rate.

When the water flow passage in the cooler 5 is divided into multiple branches, the heat removal rate calculated individually for each of the multiple branches may be determined as the heat removal rate of the cooler 5. When the water flow passage in the water-cooled housing 20 is divided into multiple branches, the heat removal rate calculated individually for each of the multiple branches may be determined as the heat removal rate of the water-cooled housing 20. With temperature sensors at both the outlet and the inlet of each system, the furnace information obtainer 514 can determine the heat removal rate of each system in the same manner as described above. The furnace information obtainer 514 may also receive, from the controller 50, the heat removal rate of the cooler 5 calculated by the controller 50 for the casting furnace 2. The furnace information obtainer 514 may also receive, from the controller 50, the heat removal rate of the water-cooled housing 20 calculated by the controller 50. The heat removal rate information may not include the heat removal rate of the water-cooled housing 20.

The mold temperature information includes, for example, at least one of the mold temperatures detected by the mold temperature sensors 13a, 13b, 13c, 13d, 13e, and 13f. In the solidification process, the mold temperature information affects the liquid phase ratio of the silicon material 200. The furnace information obtainer 514 can request the controller 50 to transmit the detection results from the mold temperature sensors 13a, 13b, 13c, 13d, 13e, and 13f through the interface 530 at every predetermined elapsed time. The controller 50 can transmit, as requested from the control device 500, the detection results from the mold temperature sensors 13a, 13b, 13c, 13d, 13e, and 13f to the control device 500. This allows the furnace information obtainer 514 to obtain the mold temperature information at every predetermined elapsed time.

The mold temperature information may eliminate at least one of the mold temperature detected by the mold temperature sensor 13a or the mold temperature detected by the mold temperature sensor 13b. The mold temperature information may eliminate the mold temperature detected by the mold temperature sensor 13c. The mold temperature information may eliminate at least one of the mold temperature detected by the mold temperature sensor 13d, the mold temperature detected by the mold temperature sensor 13e, or the mold temperature detected by the mold temperature sensor 13f.

The vacuum pressure value in the housing 20 is measured by, for example, the pressure meter 72 in the manufacturing apparatus 1. The furnace information obtainer 514 can request the controller 50 to transmit the measured pressure value from the pressure meter 72 through the interface 530 at every predetermined elapsed time. The controller 50 can transmit, as requested from the control device 500, the measured pressure value from the pressure meter 72 to the control device 500. This allows the furnace information obtainer 514 to obtain the vacuum pressure value in the housing 20 at every predetermined elapsed time.

The flow rate of the inert gas 75 is, for example, measured by a flowmeter included in the flow controller 77 in the manufacturing apparatus 1. The flowmeter included in the flow controller 77 measures, for example, the flow rate of the inert gas 75. The furnace information obtainer 514 can request the controller 50 to transmit the measured flow rate obtained by the flowmeter through the interface 530 at every predetermined elapsed time. The controller 50 can transmit, as requested from the control device 500, the measured flow rate obtained by the flowmeter to the control device 500. This allows the furnace information obtainer 514 to obtain the flow rate of the inert gas 75 at every predetermined elapsed time.

The inert gas 75 such as an argon gas functions as a heat transfer medium. As the flow rate of the inert gas 75 supplied into the housing 20 increases, the concentration of the inert gas 75 in the housing 20 increases. This allows heat in the housing 20 to easily escape out of the housing 20 through, for example, the inert gas 75 and the water-cooled housing 20. As the degree of vacuum in the housing 20 decreases, the vacuum pump 70 reduces the amount of inert gas 75 drawn out of the housing 20, thus increasing the concentration of the inert gas 75 in the housing 20. This allows heat in the housing 20 to easily escape out of the housing 20. The heat in the housing 20 affects the liquid phase ratio. Thus, the flow rate of the inert gas 75 and the vacuum pressure value in the housing 20 affect the liquid phase ratio.

The response variables include, for example, first to N-th liquid phase ratios (N is an integer greater than or equal to 2). The first to N-th liquid phase ratios indicate the liquid phase ratios on each of N imaginary lines L defined in a predetermined section 210 of the silicon material 200. Each of the N imaginary lines L extends in the vertical direction (in other words, in the height direction of the silicon material 200). FIG. 8 is a schematic diagram illustrating example N imaginary lines L defined in the predetermined section 210 of the silicon material 200. In the example illustrated in FIG. 8, N = 6, and six imaginary lines L are defined. In response to an input of furnace information 516, the first estimator 511 outputs a dataset including the first to N-th liquid phase ratios. The first estimator 511 then outputs the dataset M times in the solidification process.

In the present embodiment, the mold temperature sensors 13a, 13b, 13c, 13d, 13e, and 13f, each of which can detect the mold temperature used for estimating the liquid phase ratio, are located on the same plane. The predetermined section 210 is the section of the silicon material 200 at a cut plane including the positions of the mold temperature sensors 13a, 13b, 13c, 13d, 13e, and 13f. In describing the silicon material 200 or the silicon ingot (in other words, the solidified silicon material 200), the direction parallel to the section 210 of the silicon material 200 and perpendicular to the vertical direction is hereafter referred to as the lateral direction.

The N imaginary lines L are defined, for example, between the lateral center and one lateral end on the section 210. More specifically, the N imaginary lines L are defined in a half of the section 210 in the lateral direction (also referred to as an imaginary-half section 211). The N imaginary lines L are defined at intervals in the lateral direction. The N imaginary lines L may or may not be at equal intervals on the imaginary-half section 211.

The N imaginary lines L include, for example, an imaginary line La (also referred to as a middle imaginary line La) including a middle portion of the section 210 in the lateral direction and an imaginary line Lb (also referred to as an end imaginary line Lb) including an end portion of the section 210 in the lateral direction. The N imaginary lines L other than the middle imaginary line La and the end imaginary line Lb of the N imaginary lines L are located between the middle imaginary line La and the end imaginary line Lb.

In the solidification process, the first estimator 511 estimates, for each of the N imaginary lines L, the liquid phase ratio of the silicon material 200 on the imaginary line L. The liquid phase ratio on an imaginary line L on the silicon material 200 refers to the ratio of the amount of the liquid portion to the total amount of the silicon material 200 on the imaginary line L. The liquid phase ratio on the imaginary line L on the silicon material 200 may also be the ratio of the height of the liquid portion to the height of the silicon material 200 on the imaginary line L. For every input of the furnace information 516, the first estimator 511 outputs the liquid phase ratio on each imaginary line L at the elapsed time included in the furnace information 516. The first estimator 511 outputs the liquid phase ratio on the imaginary line L at every predetermined elapsed time. The multiple imaginary lines L may be located between one lateral end and the other lateral end on the section 210. Example Learning Parameters Used in First Estimator

In learning the parameters used in the first estimator 511, numerous learning datasets are prepared. Each learning dataset includes furnace information 516 (also referred to as learning data) and corresponding training data. The training data is an ideal output from the first estimator 511 in response to the corresponding furnace information 516 input into the first estimator 511. The output from the first estimator 511 when the first estimator 511 receives the furnace information 516 for learning is compared with the training data corresponding to the furnace information 516. The parameters are modified based on the comparison results. This process is performed repeatedly with numerous learning datasets to learn the parameters. The parameters may be learned by the controller 510, the controller 50 in the manufacturing apparatus 1, or another computer device. The controller 510 may learn the parameters. The controller 50 may learn the parameters.

An example method for generating training data will now be described. For example, a silicon ingot for generating training data (also referred to as an ingot for generating training data) is manufactured with the manufacturing apparatus 1. For generating training data, the furnace information 516 is obtained at every elapsed time in the solidification process (also referred to as a solidification process for training data) for manufacturing the ingot for generating training data. The M pieces of furnace information 516 obtained in the solidification process for training data are each referred to as the furnace information 516 for training. The solidification process for training data yields M pieces of furnace information 516 for training.

In the solidification process for generating training data, for example, a two-color thermal image camera system (also referred to as a thermal image measurement system) constantly captures images of the upper surface of the silicon material 200 at the boundary between the inner surface of the mold 3 and the silicon material 200. In other words, the upper surface of the silicon material 200 is constantly photographed along the edge of the silicon material 200 by the thermal image camera system. The thermal image camera system may also be a thermometer. The height (in other words, the position) of the upper surface of the silicon material 200 is determined at P elapsed time points (P is an integer greater than or equal to 2) in the solidification process based on the results of photographing with the thermal image camera system (in other words, the temperature measurement results). The value of P may be set to a value of, for example, 10 or greater, which is sufficiently smaller than the value of M (e.g., several thousands). The value of P is not limited to this example.

The volume of the solid portion of the silicon material 200 at the P elapsed time points is then determined based on the height of the upper surface of the silicon material 200 at the P elapsed time points. The height of the upper surface of the silicon melt 203 (more specifically, the upper surface of the silicon material 200) varies depending on the volume of the solid portion in the silicon material 200. Thus, the volume of the solid portion of the silicon material 200 at each of the P elapsed time points can be determined based on the height of the upper surface of the silicon material 200 at each of the P elapsed time points in the solidification process. The volume of the solid portion in the silicon material 200 identified in generating the training data may be hereafter referred to as a specific individual partial volume.

In generating training data, a ρb distribution on the imaginary-half section 211 of the manufactured ingot for generating training data is measured. The value of ρb is the resistance of the crystal silicon (also referred to as relative resistance). The distribution of the measured ρb is then virtually superimposed on the imaginary-half section 211 of the ingot for generating training data. The value of ρb can be measured with a predetermined measuring device. The imaginary-half section 211 on which the distribution of ρb is virtually superimposed is hereafter referred to as a pb-superimposed section 211. The pb-superimposed section 211 indicates ρb at the corresponding position on the imaginary-half section 211.

A line LL drawn in the lateral direction with the same value as ρb on the ρb-superimposed section 211 indicates the solid-liquid interface at the imaginary-half section 211 at a certain elapsed time (in other words, at a certain elapsed time point) in the solidification process for training data. Thus, the line LL indicates the solid-liquid interface profile on the imaginary-half section 211 at a certain elapsed time. The lines LL are hereafter referred to as contour lines LL.

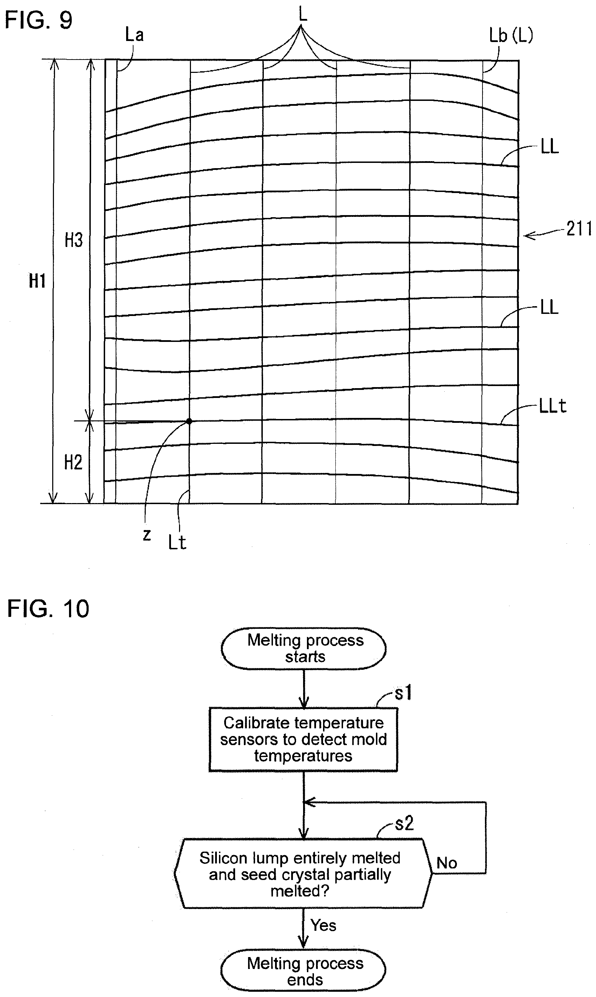

FIG. 9 is a schematic diagram illustrating example multiple contour lines LL drawn on the pb-superimposed section 211. FIG. 9 illustrates an imaginary-half section 211 with its lateral direction parallel to the right-left direction of FIG. 9.

The contour lines LL each indicate the solid-liquid interface on the imaginary-half section 211 at a certain elapsed time. Thus, the ingot for generating training data includes a portion below a contour line LL indicating a solid-liquid interface at a certain elapsed time. The portion below the contour line LL is a solid portion of the silicon material 200 at the certain elapsed time. A portion of the ingot for generating training data below a contour line LL indicating a solid-liquid interface at a certain elapsed time may be hereafter referred to as a solid portion corresponding to the contour line LL. In the ingot for generating training data, a contour line LL corresponding to a solid state portion at a certain elapsed time (in other words, at a certain elapsed time point) in the solidification process refers to a contour line LL indicating a solid-liquid interface at the certain elapsed time point.

In generating training data, P liquid phase ratios on each imaginary line L are obtained based on a specific solid state portion at the P elapsed time points obtained with the thermal image camera system and on the pb-superimposed section 211. Of the P elapsed time points, an elapsed time point to be focused on is hereafter referred to as a target elapsed time point. An imaginary line L to be focused on is referred to as a target imaginary line Lt.

For an ingot for generating training data, for example, a contour line LL corresponding to a solid portion with the same volume as a specific solid portion at the target elapsed time point (also referred to as a target elapsed time) is specified. An intersection z between the specified contour line LL (also referred to as a specific contour line LLt) and a target imaginary line Lt is then specified on the pb-superimposed section 211. The intersection z between the target imaginary line Lt and the specific contour line LLt indicates a height H2 of the solid-liquid interface on the target imaginary line Lt at the target elapsed time point. The height H2 of the solid-liquid interface on the target imaginary line Lt at the target elapsed time point can thus be determined. FIG. 9 illustrates examples of the target imaginary line Lt, the specific contour line LLt, and the intersection z.

In generating training data, the value obtained by subtracting the height H2 from a height H1 of the ingot for generating training data on the target imaginary line Lt is used as a height H3 of a liquid portion on the target imaginary line Lt at the target elapsed time point (refer to FIG. 9). The ratio of the value H3 to the height H1 is determined as a liquid phase ratio on the target imaginary line Lt at the target elapsed time point.

In this manner, the liquid phase ratio on the target imaginary line Lt at each of the P elapsed time points is obtained. The liquid phase ratio on each of the N imaginary lines L at each of the P elapsed time points is obtained. This yields P liquid phase ratios for each imaginary line L.

Subsequently, the liquid phase ratio on the target imaginary line Lt for each of M estimation elapsed times in the estimation elapsed time set is obtained by interpolating P liquid phase ratios on the target imaginary line Lt. In other words, the P liquid phase ratios on the target imaginary line Lt are interpolated to obtain liquid phase ratios on the target imaginary line Lt at the M estimation elapsed times. This yields M liquid phase ratios on the target imaginary line Lt. Similarly, the liquid phase ratio on the target imaginary line Lt at each estimation elapsed time is obtained for each imaginary line L. This yields, for each imaginary line L, M liquid phase ratios corresponding to the M estimation elapsed times included in M pieces of furnace information 516 obtained in the solidification process for training data.

In generating training data, the liquid phase ratios on the N imaginary lines L at an estimation elapsed time are the training data corresponding to the furnace information 516 at the estimation elapsed time. More specifically, a learning dataset includes the furnace information 516 at an estimation elapsed time and training data including the liquid phase ratios on the N imaginary lines L at the estimation elapsed time. An ingot for generating training data is manufactured to generate M learning datasets. An ingot for generating training data is then manufactured multiple times to prepare numerous learning datasets. The numerous learning datasets prepared in this manner are then used for learning parameters to be used by the first estimator 511.

The first estimator 511 may use a machine learning method other than a random forest. The first estimator 511 may use, for example, deep learning as its machine learning method. In some embodiments, the first estimator 511 may estimate liquid phase ratios without using machine learning.

### Operation Example of Second Estimator

The second estimator 512 can estimate the state information 517 at each estimation elapsed time based on the corresponding one of the first to N-th liquid phase ratios at the estimation elapsed time output from the first estimator 511. An estimation elapsed time to be focused on may be hereafter referred to as a target estimation elapsed time.

The state information 517 at the target estimation elapsed time includes the solidification ratio of the silicon material 200 at the target estimation elapsed time (also referred to as the solidification ratio at the target estimation elapsed time), the solidification rate of the silicon material 200 at the target estimation elapsed time (also referred to as the solidification rate at the target estimation elapsed time), and interface profile information about the solid-liquid interface profile of the silicon material 200 at the target estimation elapsed time (also referred to as interface profile information at the target estimation elapsed time). The second estimator 512 can estimate the solidification ratio, the solidification rate, and the interface profile information at the target estimation elapsed time based on the corresponding one of the first to N-th liquid phase ratios at the target estimation elapsed time output from the first estimator 511.

The solidification ratio included in the state information 517 is, for example, the approximate solidification ratio of the entire silicon material 200, rather than the solidification ratio on each imaginary line L. The second estimator 512 obtains, for example, the average of the first to N-th liquid phrase ratios at the target estimation elapsed time. The second estimator 512 then subtracts the calculated average from 100% and adds the resultant difference as the solidification ratio at the target estimation elapsed time to the state information 517. A representative value (e.g., a median) of the first to N-th liquid phase ratios at the target estimation elapsed time may be used in place of the average of the first to N-th liquid phrase ratios at the target estimation elapsed time.

The solidification rate included in the state information 517 is, for example, the approximate solidification rate of the entire silicon material 200, rather than the solidification rate on each imaginary line L. The second estimator 512 obtains the solidification rate on each target imaginary line L at the target estimation elapsed time. A time point preceding the target estimation elapsed time by a predetermined time is referred to as a reference time point. A time period from the reference time point to the target estimation elapsed time is referred to as a unit time. The reference time point may be, for example, a time point immediately preceding the target estimation elapsed time. The second estimator 512 obtains the distance by which the material solidifies on the target imaginary line L during the period from the reference point to the target estimation elapsed time point on the target imaginary line L as a solidification distance at the target estimation elapsed time on the target imaginary line L. The second estimator 512 then determines the value obtained by dividing the solidification distance by the unit time as the solidification rate on the target imaginary line L at the target estimation elapsed time. The second estimator 512 obtains the solidification rate on each of the N imaginary lines L at the target estimation elapsed time. The second estimator 512 then adds the obtained average of N solidification rates as the solidification rate at the target estimation elapsed time to the state information 517. A representative value (e.g., a median) of the N solidification rates may be used in place of the average of the N solidification rates.

The solidification distance on the target imaginary line L at the target estimation elapsed time is obtained based on the liquid phase ratio on the target imaginary line L at the target estimation elapsed time. The liquid phase ratio on the target imaginary line L at the target estimation elapsed time is referred to as a target liquid phase ratio. The liquid phase ratio on the target imaginary line L at an estimation elapsed time immediately preceding the target estimation elapsed time is referred to as an immediately preceding target liquid phase ratio. The second estimator 512 identifies, as a first position, the position of the upper surface of the solid portion on the target imaginary line at the target estimation elapsed time based on the target liquid phase ratio and the height of the upper surface of the silicon material 200 in the solidification process (also referred to as the upper surface height of the silicon material 200). The upper surface height of the silicon material 200 used by the second estimator 512 is, for example, a fixed value and is prestored in the storage 520. The second estimator 512 identifies, as a second position, the position of the upper surface of the solid portion on the target imaginary line at the time immediately preceding the target estimation elapsed time based on the immediately preceding target liquid phase ratio and the upper surface height of the silicon material 200. The second estimator 512 determines the distance between the first position and the second position as the solidification distance on the target imaginary line L at the target estimation elapsed time.

The interface profile information at the target estimation elapsed time includes, for example, convex information indicating whether the solid-liquid interface profile at the target estimation elapsed time is convex upward, flat, or convex downward. The convex information indicates whether the solid-liquid interface profile is convex upward, or whether the solid-liquid interface profile is convex downward. The interface profile information at the target estimation elapsed time includes the upward convex degree of a solid-liquid interface profile at the target estimation elapsed time. The convex information may indicate one of being convex upward, flat, or convex downward.

The second estimator 512 obtains a first difference by subtracting a liquid phase ratio on the middle imaginary line La at the target estimation elapsed time from a liquid phase ratio on the end imaginary line Lb at the target estimation elapsed time. The first difference indicates the degree by which the silicon material 200 has a higher liquid phase ratio in the middle than in the end (or the peripheral end). When the first difference is a positive value, the second estimator 512 estimates that the solid-liquid interface profile at the target estimation elapsed time is convex upward. When the first difference is zero, the second estimator 512 estimates that the solid-liquid interface profile at the target estimation elapsed time is flat. When the first difference is a negative value, the second estimator 512 estimates that the solid-liquid interface profile at the target estimation elapsed time is convex downward.

The second estimator 512 identifies, as a middle position of the upper surface of the solid portion, the position of the upper surface of the solid portion on the middle imaginary line La at the target estimation elapsed time based on the liquid phase ratio at the middle imaginary line La at the target estimation elapsed time and on the upper surface height of the silicon material 200. The position of the upper surface of the solid portion on the imaginary line L is also the position of the solid-liquid interface on the imaginary line L. The second estimator 512 identifies, as an end position of the upper surface of the solid portion, the position of the upper surface of the solid portion on the middle imaginary line Lb at the target estimation elapsed time based on the liquid phase ratio at the end imaginary line Lb at the target estimation elapsed time and on the upper surface height of the silicon material 200. The second estimator 512 determines a value obtained by subtracting the end position of the upper surface of the solid portion from the middle position of the upper surface of the solid portion as the upward convex degree of the solid-liquid interface profile at the target estimation elapsed time. The upward convex degree may also be an interface difference at the solid-liquid interface.

When the first difference is a positive value (or the solid-liquid interface profile is convex upward), the second estimator 512 may determine, as the upward convex degree of the solid-liquid interface profile at the target estimation elapsed time, a value obtained by subtracting the minimum height of the solid-liquid interface at the target estimation elapsed time from the maximum height of the solid-liquid interface at the target estimation elapsed time. In this case, for example, the second estimator 512 specifies an imaginary line L with the maximum liquid phase ratio, of the N imaginary lines L, as a liquid phase ratio maximum imaginary line L. In this case, for example, the second estimator 512 specifies an imaginary line L with the minimum liquid phase ratio of the N imaginary lines L as a liquid phase ratio minimum imaginary line L. The second estimator 512 identifies the position of the upper surface of the solid portion on the liquid phase ratio maximum imaginary line L at the target estimation elapsed time based on the liquid phase ratio at the liquid phase ratio maximum imaginary line L at the target estimation elapsed time and on the upper surface height of the silicon material 200. The second estimator 512 determines the identified position as the minimum height of the solid-liquid interface at the target estimation elapsed time. The second estimator 512 identifies the position of the upper surface of the solid portion on the liquid phase ratio minimum imaginary line L at the target estimation elapsed time based on the liquid phase ratio at the liquid phase ratio minimum imaginary line L at the target estimation elapsed time and on the upper surface height of the silicon material 200. The second estimator 512 determines the identified position as the maximum height of the solid-liquid interface at the target estimation elapsed time.

The second estimator 512 may determine, as the upward convex degree of the solid-liquid interface profile at the target estimation elapsed time, a value obtained by subtracting a liquid phase ratio on the middle imaginary line La at target estimation elapsed time from a liquid phase ratio on the end imaginary line Lb at the target estimation elapsed time.

### Operation Example of Control Device in Melting Process

FIG. 10 is a schematic flowchart of an operation example of the control device 500 in the melting process. The control device 500 can control the start of the melting process performed by the manufacturing apparatus 1. When the melting process starts, the control device 500 calibrates the multiple mold temperature sensors 13 (or the mold temperature sensors 13a, 13b, 13c, 13d, 13e, and 13f) that detect the mold temperatures used for estimating the state of the silicon material 200 in step s1. The control device 500 can calibrate the multiple mold temperature sensors 13. In the melting process, the cooler 5 is away from the base plate 40a as illustrated in FIG. 2.

The controller 510 can control the upper heater 8, the first lateral upper heater 9a, the second lateral upper heater 9b, the first lateral lower heater 10a, and the second lateral lower heater 10b to allow the multiple heater temperature sensors 12 to each detect a predetermined temperature. In the calibration process, the controller 510 in the control device 500 first controls the upper heater 8, the first lateral upper heater 9a, the second lateral upper heater 9b, the first lateral lower heater 10a, and the second lateral lower heater 10b to allow the multiple heater temperature sensors 12 (or the heater temperature sensors 12a, 12b, 12c, 12d, and 12e) to each detect, for example, a temperature of 1000 °C. The controller 510 then waits until the detection results from the multiple mold temperature sensors 13 are stable. Upon stabilization of the detection results from the mold temperature sensors 13, the controller 510 stores the mold temperature detected by each mold temperature sensor 13 as a first detection temperature into the storage 520.

The controller 510 then controls the upper heater 8, the first lateral upper heater 9a, the second lateral upper heater 9b, the first lateral lower heater 10a, and the second lateral lower heater 10b to allow the multiple heater temperature sensors 12 to each detect, for example, a temperature of 1300 °C. The controller 510 then waits until the detection results from the multiple mold temperature sensors 13 are stable. Upon stabilization of the detection results from the mold temperature sensors 13, the controller 510 stores the mold temperature detected by each mold temperature sensor 13 as a second detection temperature into the storage 520.

The controller 510 then controls the upper heater 8, the first lateral upper heater 9a, the second lateral upper heater 9b, the first lateral lower heater 10a, and the second lateral lower heater 10b to allow the multiple heater temperature sensors 12 to each detect, for example, a temperature of 1500 °C. When the temperatures of the upper heater 8, the first lateral upper heater 9a, the second lateral upper heater 9b, the first lateral lower heater 10a, and the second lateral lower heater 10b reach 1500 °C, a silicon lump in the mold 3 is melted. The controller 510 then waits until the detection results from the multiple mold temperature sensors 13 are stable. Upon stabilization of the detection results from the mold temperature sensors, the controller 510 stores the mold temperature detected by each mold temperature sensor 13 as a third detection temperature into the storage 520.

The controller 510 then compares the first, second, and third detection temperatures of each mold temperature sensor 13 with first, second, and third reference temperatures to calculate a temperature correction coefficient. The temperature correction coefficient is obtained for each mold temperature sensor 13. This ends the processing in step s1. The controller 510 can compare the first, second, and third detection temperatures of each mold temperature sensor 13 with first, second, and third reference temperatures to calculate a temperature correction coefficient. The first reference temperature is an ideal value of the first detection temperature. The second reference temperature is an ideal value of the second detection temperature. The third reference temperature is an ideal value of the third detection temperature. The storage 520 prestores the first, second, and third reference temperatures for each mold temperature sensor 13. The controller 501 stores the calculated temperature correction coefficients into the storage 520. The storage 520 stores multiple temperature correction coefficients corresponding to the multiple mold temperature sensors 13.

When receiving a detection result from the temperature sensor 13 from the controller 50, the furnace information obtainer 514 in the controller 510 corrects the received detection result with the temperature correction coefficient for the corresponding temperature sensor 13 in the storage 520. More specifically, the furnace information obtainer 514 corrects the detection result by multiplying the detection result from the temperature sensor 13 by the temperature correction coefficient for the temperature sensor 13. The furnace information obtainer 514 then inputs the furnace information 516 including the corrected detection result into the first estimator 511. The first estimator 511 thus uses the corrected detection result from the temperature sensor 13 with the temperature correction coefficient to estimate the state of the silicon material 200, rather than using the detection result without any change. The furnace information obtainer 514 can correct the detection result from the temperature sensor 13 with the temperature correction coefficient for the temperature sensor 13 in the storage 520.

After the correction process in step s1 ends in the melting process, step s2 is performed. The controller 510 can determine whether the silicon lump in the mold 3 is entirely melted and the seed crystal 201 in the mold 3 is partially melted. **In** step s2, the controller 510 determines whether the silicon lump in the mold 3 is entirely melted and the seed crystal 201 in the mold 3 is partially melted based on the detection result from the mold temperature sensor 13g that detects the temperature of the bottom wall 3f of the mold 3. The controller 510 can determine whether the silicon lump in the mold 3 is entirely melted and the seed crystal 201 in the mold 3 is partially melted based on a change in the temperature gradient detected by the mold temperature sensor 13g. In response to a negative determination result in step s2, step s2 is performed again after a predetermined time. When the determination result is affirmative in step s2, the melting process ends. Thus, when the silicon lump is entirely melted and the seed crystal 201 is partially melted, the melting process ends.

### Operation Example of Control Device in Solidification Process

After the melting process ends, the cooler 5 in the casting furnace 2 is raised and comes in contact with the base plate 40a as illustrated in FIG. 3. This starts the solidification process. In the present embodiment, the elapsed time from the start of the solidification process is an elapsed time from when the cooler 5 comes in contact with the base plate 40a. The control device 500 can control the start of the solidification process performed by the manufacturing apparatus 1.

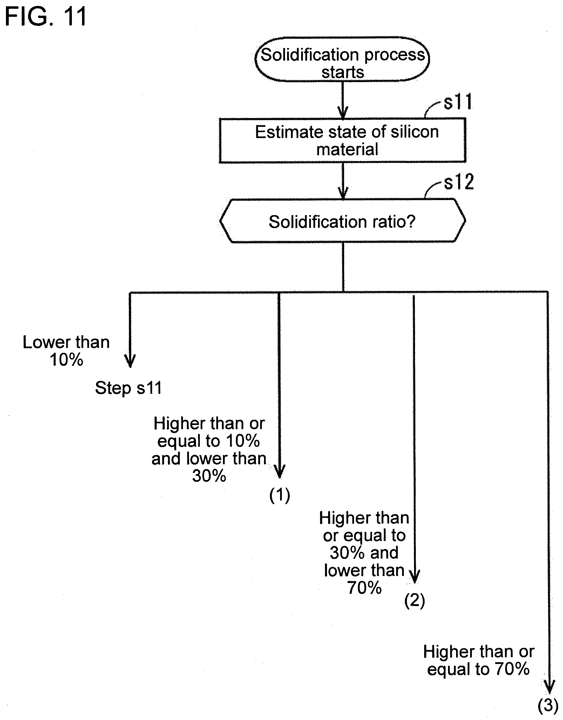

FIGs. 11 to 14 are each a schematic flowchart of an operation example of the control device 500 in the solidification process. In the present embodiment, the solid-liquid interface profile may be ideally, for example, convex upward, and each heater is controlled to cause the solid-liquid interface profile to be as convex upward as possible. The heater controller 515 can control the temperature of each heater based on the temperature profile 522 in the storage 520. In the solidification process, the heater controller 515 controls the temperature of each heater based on the temperature profile 522 in the storage 520. The temperature profile 522 includes a temperature setting value of each heater at the corresponding estimation elapsed time in the solidification process. The first lateral upper heater 9a and the second lateral upper heater 9b in the lateral upper heaters 9 are set at the same temperature. The first lateral lower heater 10a and the second lateral lower heater 10b in the lateral lower heaters 10 are set at the same temperature.

The liquid-fluid interface profile may also be ideally convex upward for another material to be solidified, in addition to silicon. Thus, the solid-liquid interface profile may be ideally convex upward in the solidification process for any inorganic material other than silicon to be solidified (refer to, for example, Patent Literatures 3 and 4). More specifically, when the solid-liquid interface profile is convex upward, the crystal grows from the center of the crucible toward the periphery of the crucible, and dislocations in the crystal with the crystal growth thus easily propagate toward the periphery of the crucible. This reduces the dislocations propagating toward the center of the crucible, thus improving the crystal quality.

The heater controller 515 basically controls the heaters based on the temperature profile 522. More specifically, the heater controller 515 basically controls the output power of the upper heater 8 to cause the temperature of the upper heater 8 detected by the heater temperature sensor 12a at each estimation elapsed time to be the temperature setting value indicated by the temperature profile 522. The heater controller 515 basically controls the output power of the first lateral upper heater 9a to cause the temperature of the first lateral upper heater 9a detected by the heater temperature sensor 12b at each estimation elapsed time to be the temperature setting value indicated by the temperature profile 522. The heater controller 515 basically controls the output power of the second lateral upper heater 9b to cause the temperature of the second lateral upper heater 9b detected by the heater temperature sensor 12c at each estimation elapsed time to be the temperature setting value indicated by the temperature profile 522. The heater controller 515 basically controls the output power of the first lateral lower heater 10a to cause the temperature of the first lateral lower heater 10a detected by the heater temperature sensor 12d at each estimation elapsed time to be the temperature setting value indicated by the temperature profile 522. The heater controller 515 basically controls the output power of the second lateral lower heater 10b to cause the temperature of the second lateral lower heater 10b detected by the heater temperature sensor 12e at each estimation elapsed time to be the temperature setting value indicated by the temperature profile 522. In response to the state of the silicon material 200, the heater controller 515 may change the temperature of each heater from the temperature setting value indicated by the temperature profile 522.

The storage 520 stores the ideal state information 523 indicating the ideal state of the silicon material 200 at each estimation elapsed time. The ideal state information 523 includes multiple solidification ratios. The ideal state information 523 includes an appropriate range (or an ideal range) of solidification rates for each solidification ratio. The ideal state information 523 includes an appropriate range (or an ideal range) of upward convex degrees for each solidification ratio. The ideal state information 523 includes an appropriate range of solidification rates and an appropriate range of upward convex degrees for, for example, a solidification ratio of 1%. The heater controller 515 can compare the state of the silicon material 200 estimated by the estimator 513 with the ideal state information 523, and change, based on the comparison result, the temperature of the heater from the temperature setting value indicated by the temperature profile 522.

When the solidification process starts, the processing in step s11 is performed first. In step s 11, the state of the silicon material 200 at the current estimation elapsed time is estimated. More specifically, in step s11, the furnace information obtainer 514 obtains the furnace information 516 at the current estimation elapsed time, and the estimator 513 estimates the state information 517 based on the obtained furnace information 516. As described later, the processing in step s11 is performed repeatedly. For example, the processing in step s11 is performed every minute. The processing in step s11 is performed repeatedly to estimate the state information 517 at each estimation elapsed time. The state of the silicon material 200 at each estimation elapsed time is thus estimated.

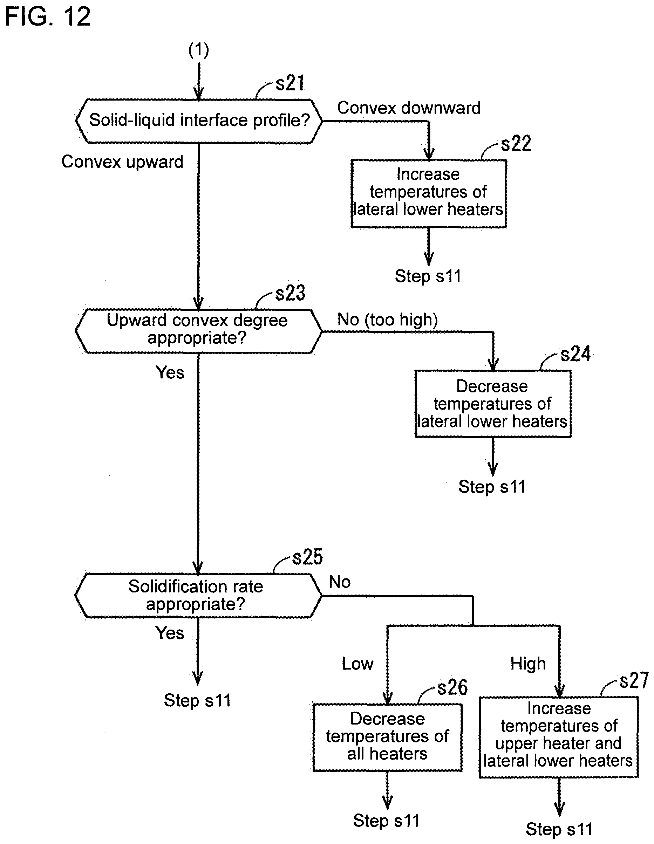

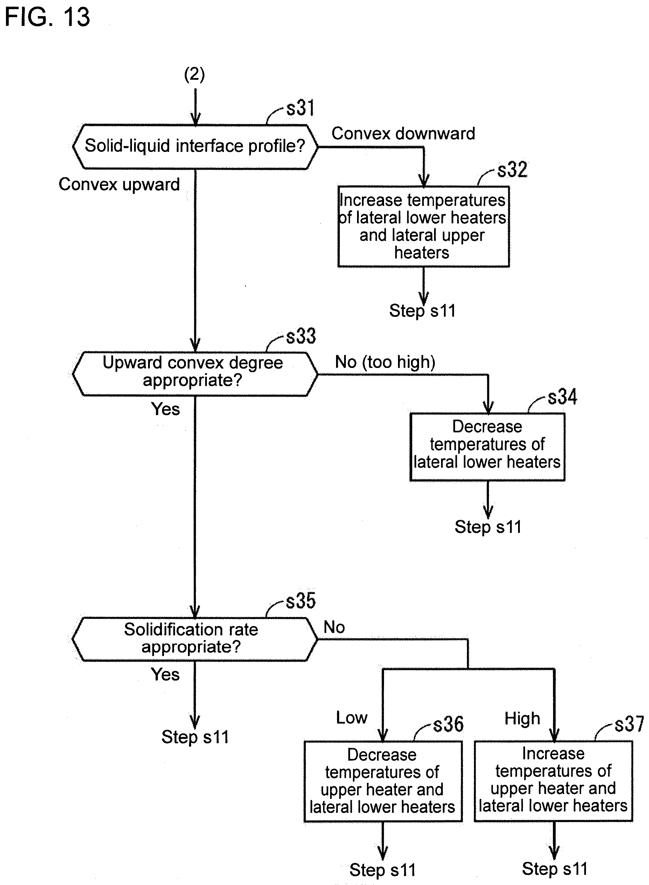

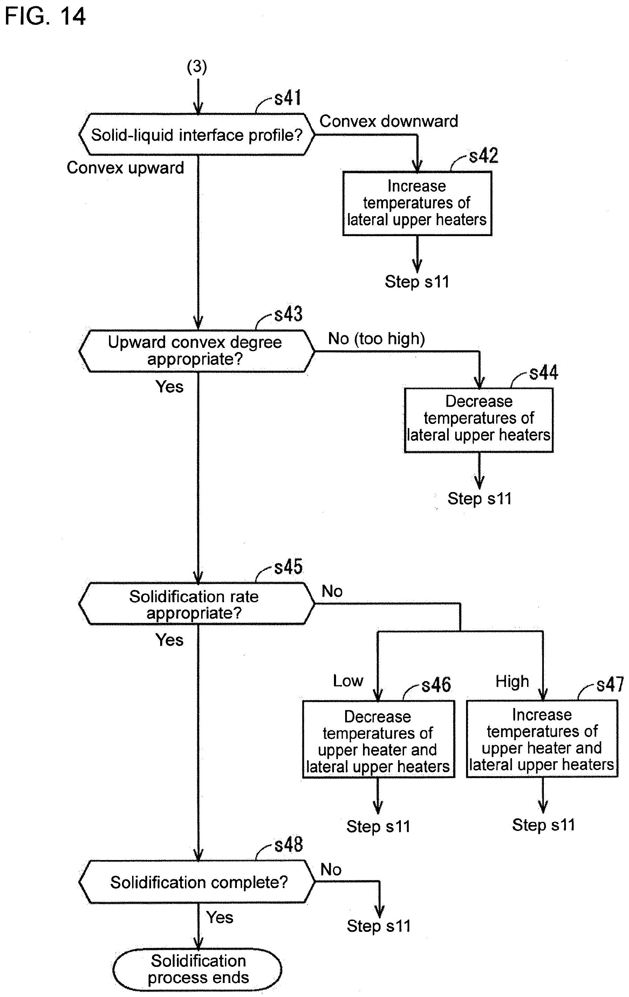

In step s12, the heater controller 515 refers to the current solidification ratio, or more specifically, the solidification ratio included in the state information 517 estimated in step s11. When, for example, the current solidification ratio is lower than 10%, the processing in step s11 is performed again. When, for example, the current solidification ratio is higher than or equal to 10% and is lower than 30%, the processing in step s21 in FIG. 12 is performed. When, for example, the current solidification ratio is higher than or equal to 30% and is lower than 70%, the processing step s31 in FIG. 13 is performed. When, for example, the current solidification ratio is higher than or equal to 70%, the processing in step s41 in FIG. 14 is performed.

When the current solidification ratio is 10%, the processing in step s11 or s21 may be performed. When the current solidification ratio is 30%, the processing in step s21 or s31 may be performed. When the current solidification ratio is 70%, the processing in step s31 or s41 may be performed. When the current solidification ratio is higher than or equal to 0% and is lower than 10% or lower than or equal to 10%, the processing in step s21 may be performed.

A threshold for a first solidification ratio is, for example, 10%. A threshold for a second solidification ratio is, for example, 70%. The processing in step s21 is performed when the current solidification ratio is lower than the threshold for the first solidification ratio. The processing in step s31 is performed when the current solidification ratio is higher than the threshold for the first solidification ratio and is lower than the threshold for the second solidification ratio. The processing in step s41 is performed when the current solidification ratio is higher than the threshold for the second solidification ratio. The threshold for the first solidification ratio may be other than 10%. The threshold for the second solidification ratio may be other than 70%.

The heater controller 515 can determine whether the current solid-liquid interface profile is convex upward or is convex downward based on the convex information included in the state information 517. In step s21 in FIG. 12, the heater controller 515 determines whether the current solid-liquid interface profile is convex upward or is convex downward based on the convex information included in the state information 517 estimated in step s11. When the current solid-liquid interface profile is determined to be convex downward in step s21, the processing in step s22 is performed. In step s22, the heater controller 515 increases the temperatures of the lateral lower heaters 10 at the subsequent estimation elapsed time to above the temperature setting value indicated by the temperature profile 522. The processing in step s11 is then performed.

When the current solid-liquid interface profile is determined to be convex upward in step s21, the processing in step s23 is performed. The heater controller 515 can determine whether the current upward convex degree is appropriate. In step s23, the heater controller 515 determines whether the current upward convex degree, or the upward convex degree included in the state information 517 estimated in step s11, is appropriate. In step s23, the heater controller 515 obtains, from the ideal state information 523 in the storage 520, an appropriate range (also referred to as a predetermined range) of upward convex degrees for the current solidification ratio. When the current upward convex degree is within the appropriate range, the heater controller 515 returns an affirmative determination result. When the current upward convex degree is out of the appropriate range, the heater controller 515 returns a negative determination result.

When the determination result is negative in step s23, or more specifically, the current upward convex degree is determined to be too high, the processing in step s24 is performed. In step s24, the heater controller 515 decreases the temperatures of the lateral lower heaters 10 at the subsequent estimation elapsed time to below the temperature setting value indicated by the temperature profile 522.

When the determination result is affirmative in step s23, the processing in step s25 is performed. The heater controller 515 can determine whether the current solidification rate is appropriate. In step s25, the heater controller 515 determines whether the current solidification rate, or the solidification rate included in the state information 517 estimated in step s11, is appropriate. In step s25, the heater controller 515 obtains, from the ideal state information 523 in the storage 520, an appropriate range (also referred to as a predetermined rate range) of solidification rates for the current solidification ratio. When the current solidification rate is within the appropriate range, the heater controller 515 returns an affirmative determination result. When the current solidification rate is out of the appropriate range, the heater controller 515 returns a negative determination result.

When the determination result is affirmative in step s25, the processing in step s11 is performed. When the determination result is negative in step s25, the processing in step s26 or s27 is performed. When the current solidification rate is lower than the appropriate range (or the predetermined rate range), or more specifically, the current solidification rate is too low, the processing in step s26 is performed. When the current solidification rate is higher than the appropriate range (or the predetermined rate range), or more specifically, the current solidification rate is too high, the processing in step s27 is performed. In step s26, the heater controller 515 decreases the temperatures of all the heaters at the subsequent estimation elapsed time to below the temperature setting values indicated by the temperature profile 522. In step s27, the heater controller 515 increases the temperatures of the upper heater 8 and the lateral lower heaters 10 at the subsequent estimation elapsed time to above the temperature setting values indicated by the temperature profile 522. After step s26, the processing in step s11 is performed. After step s27, the processing in step s11 is performed.

In the present embodiment, the heater controller 515 increases the temperatures of the lateral lower heaters 10 to above the temperature setting value when the solidification ratio is lower than the threshold for the first solidification ratio and the solid-liquid interface profile is convex downward (step s22). More specifically, the heater controller 515 increases the temperatures of the lateral lower heaters 10 to above the temperature setting value when the solidification ratio is low and the solid-liquid interface profile is convex downward. When the solidification ratio is low, the temperatures of the lateral lower heaters 10 are increased to reduce the likelihood that the silicon melt 203 has a solidified end (or a solidified peripheral end). The solid-liquid interface profile is thus likely to be convex upward. The temperatures of the lateral lower heaters 10 are increased to cause a slight increase in the temperature of the entire silicon material 200. Thus, the temperature of the upper heater 8 not greatly affecting the solid-liquid interface profile may be set slightly lower than the temperature setting value in step s22 to cause a slight decrease in the temperature of the entire silicon material 200.

In the present embodiment, the heater controller 515 decreases the temperatures of the lateral lower heaters 10 to below the temperature setting value when the solidification ratio is lower than the threshold for the first solidification ratio, the solid-liquid interface profile is convex upward, and the upward convex degree is higher than the predetermined range (step s24). When the solidification ratio is low, the temperatures of the lateral lower heaters 10 are decreased to increase the likelihood that the silicon melt 203 has a solidified end. This reduces the upward convex degree of the solid-liquid interface profile. The temperatures of the lateral lower heaters 10 are decreased to cause a slight decrease in the temperature of the entire silicon material 200. Thus, the temperature of the upper heater 8 not greatly affecting the solid-liquid interface profile may be set slightly higher than the temperature setting value in step s24 to cause a slight increase in the temperature of the entire silicon material 200.

In the present embodiment, when the solidification rate is lower than the predetermined rate range, the heater controller 515 decreases the temperature of the upper heater 8 to below the temperature setting value (step s26). Decreasing the temperature of the upper heater 8 increases the solidification rate of the entire silicon melt 203, thus allowing the solidification rate to approach the appropriate range.

In the present embodiment, when the solidification rate is higher than the predetermined rate range, the heater controller 515 increases the temperature of the upper heater 8 to above the temperature setting value (step s27). Increasing the temperature of the upper heater 8 reduces the solidification rate of the entire silicon melt 203, thus allowing the solidification rate to approach the appropriate range.

In step s26, the heater controller 515 may decrease the temperature of the upper heater 8 alone from the temperature setting value. In step s27, the heater controller 515 may increase the temperatures of all the heaters from the temperature setting values. In step s27, the heater controller 515 may increase the temperature of the upper heater 8 alone from the temperature setting value.

Step s31 in FIG. 13 is the same as or similar to step s21. When the current solid-liquid interface profile is determined to be convex downward in step s31, the processing in step s32 is performed. In step s32, the heater controller 515 increases the temperatures of the lateral lower heaters 10 and the lateral upper heaters 9 at the subsequent estimation elapsed time to above the temperature setting values indicated by the temperature profile 522. The processing in step s11 is then performed. In step s32, the heater controller 515 may increase the temperatures of the lateral lower heaters 10 alone to above the temperature setting value.

When the current solid-liquid interface profile is determined to be convex upward in step s31, the processing in step s33 is performed. Step s33 is the same as or similar to step s23. When the determination result is negative in step s33, the processing in step s34 is performed. In step s34, the heater controller 515 decreases the temperatures of the lateral lower heaters 10 at the subsequent estimation elapsed time to below the temperature setting value indicated by the temperature profile 522. In step s34, the heater controller 515 may decrease the temperatures of the lateral lower heaters 10 and the lateral upper heaters 9 to below the temperature setting values indicated by the temperature profile 522.

When the determination result is affirmative in step s33, the processing in step s35 is performed. Step s35 is the same as or similar to step s25. When the determination result is affirmative in step s35, the processing in step s11 is performed. When the determination result is negative in step s35, the processing in step s36 or s37 is performed. When the current solidification rate is lower than the appropriate range, the processing in step s36 is performed. When the current solidification rate is higher than the appropriate range, the processing in step s37 is performed. In step s36, the heater controller 515 decreases the temperatures of the upper heater 8 and the lateral lower heaters at the subsequent estimation elapsed time to below the temperature setting values indicated by the temperature profile 522. In step s37, the heater controller 515 increases the temperatures of the upper heater 8 and the lateral lower heaters 10 at the subsequent estimation elapsed time to above the temperature setting values indicated by the temperature profile 522. After step s36, the processing in step s11 is performed. After step s37, the processing in step s11 is performed.

In step s36, the heater controller 515 may decrease the temperatures of all the heaters to below the temperature setting values. In step s36, the heater controller 515 may decrease the temperature of the upper heater 8 alone to below the temperature setting value. In step s37, the heater controller 515 may increase the temperatures of all the heaters to above the temperature setting values. In step s37, the heater controller 515 may increase the temperature of the upper heater 8 alone to above the temperature setting value.

In the present embodiment, the heater controller 515 increases the temperatures of at least the lateral lower heaters 10, of the lateral upper heaters 9 and the lateral lower heaters 10, to above the temperature setting value when the solidification ratio is higher than the threshold for the first solidification ratio and is lower than the threshold for the second solidification ratio (step s32). More specifically, the heater controller 515 increases the temperatures of at least the lateral lower heaters 10, of the lateral upper heaters 9 and the lateral lower heaters 10, to above the temperature setting value when the solidification ratio is moderate and the solid-liquid interface profile is convex downward. When the solidification ratio is moderate, the temperatures of at least the lateral lower heaters 10, of the lateral upper heaters 9 and the lateral lower heaters 10, are increased to reduce the likelihood that the silicon melt 203 has a solidified end. The solid-liquid interface profile is thus likely to be convex upward. The temperatures of at least the lateral lower heaters 10, of the lateral upper heaters 9 and the lateral lower heaters 10, are increased to cause a slight increase in the temperature of the entire silicon material 200. Thus, the temperature of the upper heater 8 not greatly affecting the solid-liquid interface profile may be set slightly lower than the temperature setting value in step s32 to cause a slight decrease in the temperature of the entire silicon material 200.

In the present embodiment, the heater controller 515 decreases the temperatures of at least the lateral lower heaters 10, of the lateral upper heaters 9 and the lateral lower heaters 10, to below the temperature setting value when the solidification ratio is higher than the threshold for the first solidification ratio and is lower than the threshold for the second solidification ratio, the solid-liquid interface profile is convex upward, and the upward convex degree is higher than the predetermined range (step s34). When the solidification ratio is moderate, the temperatures of at least the lateral lower heaters 10, of the lateral upper heaters 9 and the lateral lower heaters 10, are decreased to increase the likelihood that the silicon melt 203 has a solidified end. This reduces the upward convex degree of the solid-liquid interface profile. The temperatures of at least the lateral lower heaters 10, of the lateral upper heaters 9 and the lateral lower heaters 10, are decreased to cause a slight decrease in the temperature of the entire silicon material 200. Thus, the temperature of the upper heater 8 not greatly affecting the solid-liquid interface profile may be set slightly higher than the temperature setting value in step s34 to cause a slight increase in the temperature of the entire silicon material 200.

Step s41 in FIG. 14 is the same as or similar to step s21. When the current solid-liquid interface profile is determined to be convex downward in step s41, the processing in step s42 is performed. In step s42, the heater controller 515 increases the temperatures of the lateral upper heaters 9 at the subsequent estimation elapsed time to above the temperature setting value indicated by the temperature profile 522. The processing in step s11 is then performed.

When the current solid-liquid interface profile is determined to be convex upward in step s41, the processing in step s43 is performed. Step s43 is the same as or similar to step s23. When the determination result is negative in step s43, the processing in step s44 is performed. In step s44, the heater controller 515 decreases the temperatures of the lateral upper heaters 9 at the subsequent estimation elapsed time to below the temperature setting value indicated by the temperature profile 522.

When the determination result is affirmative in step s43, the processing in step s45 is performed. Step s45 is the same as or similar to step s25. When the determination result is negative in step s45, the processing in step s46 or s47 is performed. When the current solidification rate is lower than the appropriate range, the processing in step s46 is performed. When the current solidification rate is higher than the appropriate range, the processing in step s47 is performed. In step s46, the heater controller 515 decreases the temperatures of the upper heater 8 and the lateral upper heaters 9 at the subsequent estimation elapsed time to below the temperature setting values indicated by the temperature profile 522. In step s47, the heater controller 515 increases the temperatures of the upper heater 8 and the lateral upper heaters 9 at the subsequent estimation elapsed time to above the temperature setting values indicated by the temperature profile 522. After step s46, the processing in step s11 is performed. After step s47, the processing in step s11 is performed.

In step s66, the heater controller 515 may decrease the temperature of the upper heater 8 alone to below the temperature setting value. In step s47, the heater controller 515 may increase the temperature of the upper heater 8 alone to above the temperature setting value.

When the determination result is affirmative in step s45, the processing in step s48 is performed. In step s48, the controller 510 determines whether the silicon material 200 is solidified. When the determination result is negative in step s48, the processing in step s11 is performed. When the determination result is affirmative in step s48, the solidification process ends.

In the present embodiment, the heater controller 515 increases the temperatures of the lateral upper heaters 9 to above the temperature setting value when the solidification ratio is higher than the threshold for the second solidification ratio and the solid-liquid interface profile is convex downward (step s42). In other words, the heater controller 515 increases the temperatures of the lateral upper heaters 9 to above the temperature setting value when the solidification ratio is high and the solid-liquid interface profile is convex downward. When the solidification ratio is high, the temperatures of the lateral upper heaters 9 are increased to reduce the likelihood that the silicon melt 203 has a solidified end (or a solidified peripheral end). The solid-liquid interface profile is thus likely to be convex upward. The temperatures of the lateral upper heaters 9 are increased to cause a slight increase in the temperature of the entire silicon material 200. Thus, the temperature of the upper heater 8 not greatly affecting the solid-liquid interface profile may be set slightly lower than the temperature setting value in step s42 to cause a slight decrease in the temperature of the entire silicon material 200.

In the present embodiment, the heater controller 515 decreases the temperatures of the lateral upper heaters 9 to below the temperature setting value when the solidification ratio is higher than the threshold for the second solidification ratio, the solid-liquid interface profile is convex upward, and the upward convex degree is higher than the predetermined range (step s44). When the solidification ratio is high, the temperatures of the lateral upper heaters 9 are decreased to increase the likelihood that the silicon melt 203 has a solidified end. This reduces the upward convex degree of the solid-liquid interface profile. The temperatures of the lateral upper heaters 9 are decreased to cause a slight decrease in the temperature of the entire silicon material 200. Thus, the temperature of the upper heater 8 not greatly affecting the solid-liquid interface profile may be set slightly higher than the temperature setting value in step s44 to cause a slight increase in the temperature of the entire silicon material 200.

In the solidification process, the display 550 may be controlled by the controller 510 to display the state of the silicon material 200 in real time.

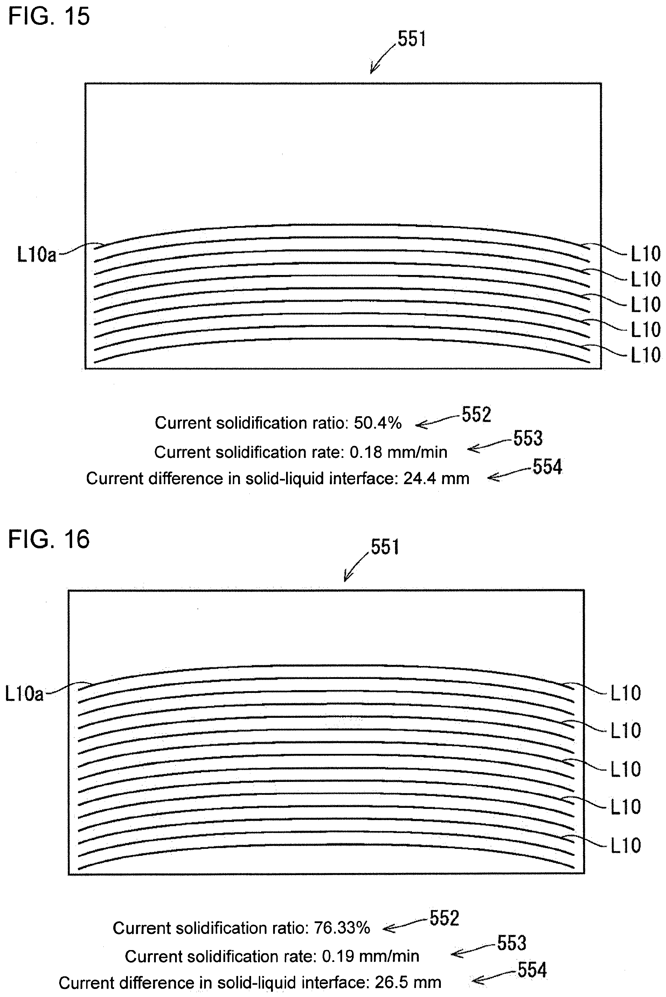

FIG. 15 is a schematic diagram of an example display on the display 550 in the solidification process. As illustrated in FIG. 15, the display 550 may display an interface profile diagram 551 indicating the profile change of the solid-liquid interface in the solidification process over the elapsed time. In the interface profile diagram 551, lines L10 each indicate the solid-liquid interface profile in the predetermined section 210 of the silicon material 200 at each estimation elapsed time. Of the multiple lines L10, a more upward line indicates a more recent solid-liquid interface profile. The uppermost line L10a indicates the current solid-liquid interface profile. The interface profile diagram 551 includes the solid-liquid interface profiles across the entire section 210. In the present embodiment, the controller 510 can estimate the solid-liquid interface profile in the section 210 at each estimation elapsed time based on the state information 517 output from the estimator 513, and generate the interface profile diagram 551 based on the estimation result. The controller 510 causes the display 550 to display the generated interface profile diagram 551. The controller 510 updates the interface profile diagram 551 over the elapsed time.

As illustrated in FIG. 15, the display 550 may display solidification ratio information 552 indicating the current solidification ratio, solidification rate information 553 indicating the current solidification rate, and difference information 554 indicating the current difference in the solid-liquid interface, for example, below the interface profile diagram 551. The current difference in the solid-liquid interface is the current upward convex degree of the solid-liquid interface profile. The difference information 554 may thus be information about the upward convex degree. FIG. 16 is a schematic diagram of an example display on the display 550 at a time elapsed after the display in FIG. 15 is performed.

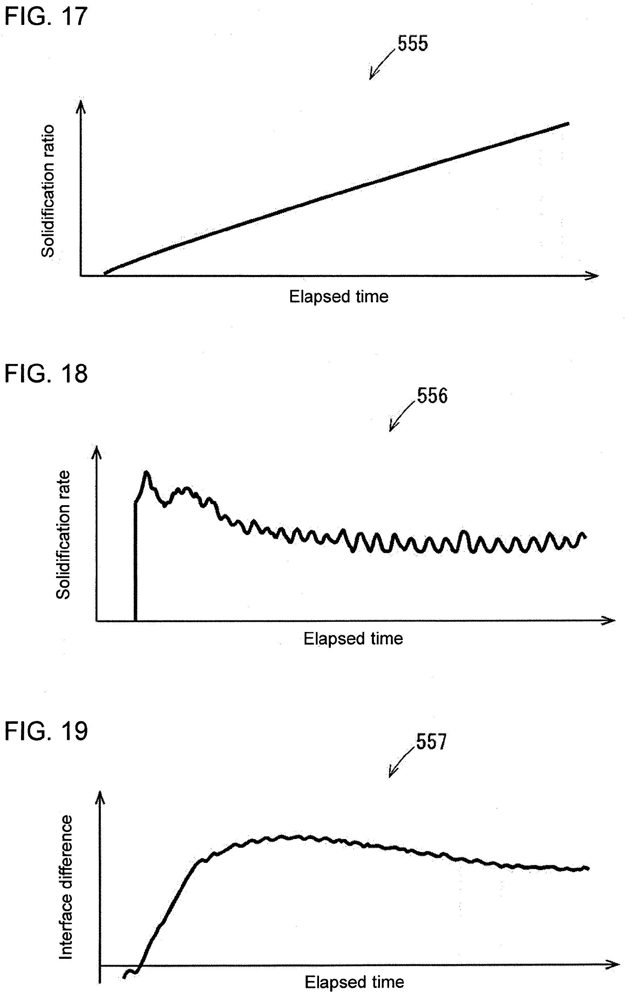

As illustrated in FIG. 17, the display 550 may display a graph 555 showing the solidification ratio at each elapsed time in chronological order. As illustrated in FIG. 18, the display 550 may display a graph 556 showing the solidification rate at each elapsed time in chronological order. As illustrated in FIG. 19, the display 550 may display a graph 557 showing the interface difference at each elapsed time in chronological order. The interface difference is the difference in the solid-liquid interface and is the upward convex degree of the liquid-fluid interface. The display 550 may simultaneously display at least two of the graphs 555, 556, or 557. The display 550 may simultaneously display at least one of the graphs 555, 556, or 557, the interface profile diagram 551, the solidification ratio information 552, the solidification rate information 553, and the difference information 554 illustrated in FIG. 15.

The display 550 may be replaced with the display 60 in the manufacturing apparatus 1 to perform the display in FIGs. 15 to 19. The display 550 and the display 60 may each perform the display in FIGs. 15 to 19. When the display 60 performs the display in FIGs. 15 to 19, the control device 500 generates a display screen and transmits the display screen to the controller 50. The control device 500 can generate a display screen and transmit the display screen to the controller 50. The controller 50 causes the display 60 to display the display screen transmitted from the control device 500.

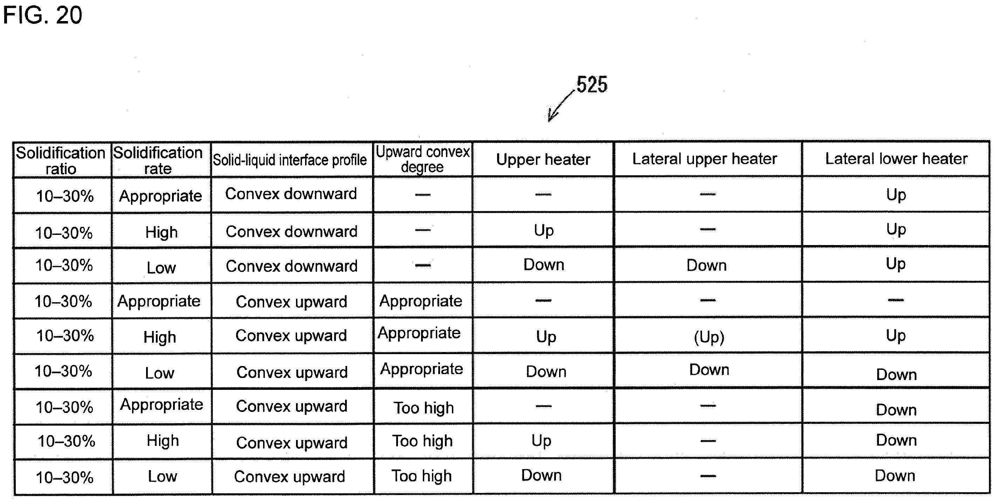

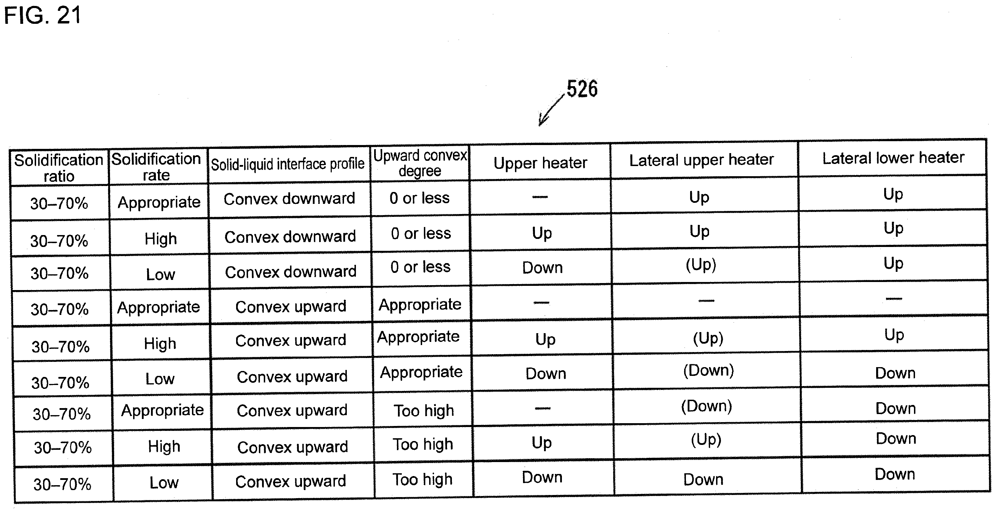

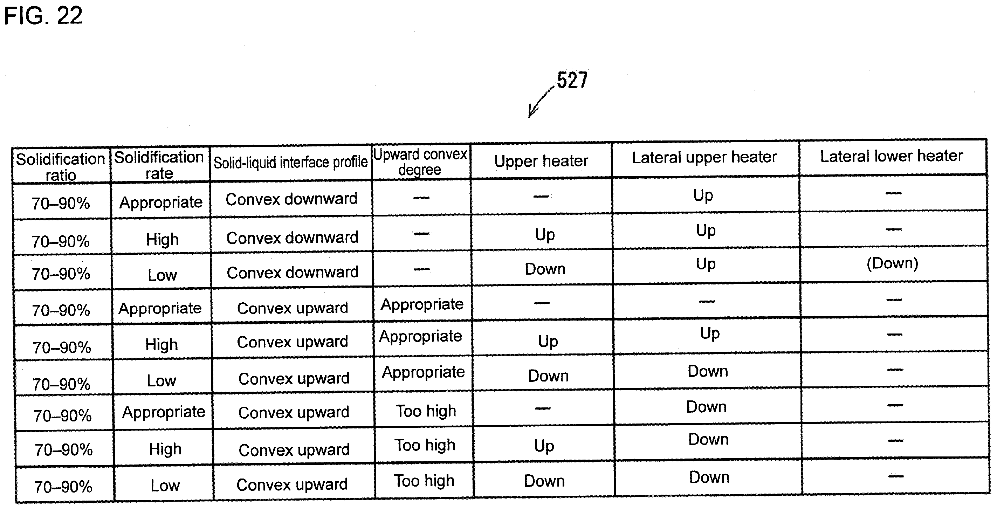

The temperature control for the heaters based on the state of the silicon material 200 in the solidification process is not limited to the above example. For example, the heater controller 515 may control the temperature of each heater based on tables 525, 526, and 527 illustrated in FIGs. 20 to 22. The tables 525, 526, and 527 are prestored in the storage 520.

In the present embodiment, the processing in step s11 is performed repeatedly as in the examples illustrated in FIGs. 11 to 14. The heater controller 515 refers to the current solidification ratio output from the estimator 513 and included in the state information 517 every time the processing in step s11 is performed. The heater controller 515 refers to the table 525 when the current solidification ratio is, for example, higher than or equal to 10% and is lower than 30%, the table 526 when the current solidification ratio is higher than or equal to 30% and is lower than 70%, and the table 527 when the current solidification ratio is higher than or equal to 70% and is lower than 90%. In the present embodiment, the heater controller 515 sets the temperature of each heater based on the temperature profile 522 without using the state information 517 when the current solidification ratio is lower than 10% or is higher than or equal to 90%.

In the tables 525, 526, and 527, up indicates that the heater temperature is to be increased to above the temperature setting value in the temperature profile 522. In the tables 525, 526, and 527, up in parentheses indicates that the heater temperature may or may not be increased to above the temperature setting value in the temperature profile 522. In the tables 525, 526, and 527, down indicates that the heater temperature is to be decreased to below the temperature setting value in the temperature profile 522. In the tables 525, 526, and 527, down in parentheses indicates that the heater temperature may or may not be decreased to below the temperature setting value in the temperature profile 522.

The operation of the heater controller 515 performed when the current solidification ratio is higher than or equal to 10% and is lower than 30% will be described first. When the current solidification rate is appropriate and the current solid-liquid interface profile is convex downward, the heater controller 515 increases the temperatures of the lateral lower heaters 10 at the subsequent estimation elapsed time to above the temperature setting value, as indicated in the top column in the table 525.

When the current solidification rate is high and the current solid-liquid interface profile is convex downward, the heater controller 515 increases the temperatures of the upper heater 8 and the lateral lower heaters 10 at the subsequent estimation elapsed time to above the temperature setting values, as indicated in the second column from the top in the table 525.

When the current solidification rate is low and the current solid-liquid interface profile is convex downward, the heater controller 515 decreases the temperatures of the upper heater 8 and the lateral upper heaters 9 at the subsequent estimation elapsed time to below the temperature setting values, and increases the temperatures of the lateral lower heaters 10 at the subsequent estimation elapsed time to above the temperature setting value, as indicated in the third column from the top in the table 525.

When the current solidification rate is appropriate, the current solid-liquid interface profile is convex upward, and the current upward convex degree is appropriate, the heater controller 515 maintains the temperature of each heater at the subsequent estimation elapsed time to be the temperature setting value, as indicated in the fourth column from the top in the table 525.

When the current solidification rate is high, the current solid-liquid interface profile is convex upward, and the current upward convex degree is appropriate, the heater controller 515 increases the temperatures of the upper heater 8 and the lateral lower heaters 10 at the subsequent estimation elapsed time to above the temperature setting values, as indicated in the fifth column from the top in the table 525. The heater controller 515 may increase the temperatures of the lateral upper heaters 9 at the subsequent estimation elapsed time from the temperature setting value.

When the current solidification rate is low, the current solid-liquid interface profile is convex upward, and the current upward convex degree is appropriate, the heater controller 515 decreases the temperature of each heater at the subsequent estimation elapsed time to below the temperature setting value, as indicated in the sixth column from the top in the table 525.

When the current solidification rate is appropriate, the current solid-liquid interface profile is convex upward, and the current upward convex degree is too high, the heater controller 515 decreases the temperatures of the lateral lower heaters 10 at the subsequent estimation elapsed time to below the temperature setting value, as indicated in the seventh column from the top in the table 525.

When the current solidification rate is high, the current solid-liquid interface profile is convex upward, and the current upward convex degree is too high, the heater controller 515 increases the temperature of the upper heater 8 at the subsequent estimation elapsed time to above the temperature setting value, and decreases the temperatures of the lateral lower heaters 10 at the subsequent estimation elapsed time to below the temperature setting value, as indicated in the eighth column from the top in the table 525.

When the current solidification rate is low, the current solid-liquid interface profile is convex upward, and the current upward convex degree is too high, the heater controller 515 decreases the temperatures of the upper heater 8 and the lateral lower heaters 10 at the subsequent estimation elapsed time to below the temperature setting values, as indicated in the bottom column in the table 525.

The operation of the heater controller 515 performed when the current solidification ratio is higher than or equal to 30% and is lower than 70% will now be described. When the current solidification rate is appropriate and the current solid-liquid interface profile is convex downward, the heater controller 515 increases the temperatures of the lateral upper heaters 9 and the lateral lower heaters 10 at the subsequent estimation elapsed time to above the temperature setting values, as indicated in the top column in the table 526.

When the current solidification rate is high and the current solid-liquid interface profile is convex downward, the heater controller 515 increases the temperature of each heater at the subsequent estimation elapsed time to above the temperature setting value, as indicated in the second column from the top in the table 526.

When the current solidification rate is low and the current solid-liquid interface profile is convex downward, the heater controller 515 decreases the temperature of the upper heater 8 at the subsequent estimation elapsed time to below the temperature setting value, and increases the temperatures of the lateral lower heaters 10 at the subsequent estimation elapsed time to above the temperature setting value, as indicated in the third column from the top in the table 526. The heater controller 515 may increase the temperatures of the lateral upper heaters 9 at the subsequent estimation elapsed time to above the temperature setting value.

When the current solidification rate is appropriate, the current solid-liquid interface profile is convex upward, and the current upward convex degree is appropriate, the heater controller 515 maintains the temperature of each heater at the subsequent estimation elapsed time to be the temperature setting value, as indicated in the fourth column from the top in the table 526.

When the current solidification rate is high, the current solid-liquid interface profile is convex upward, and the current upward convex degree is appropriate, the heater controller 515 increases the temperatures of the upper heater 8 and the lateral lower heaters 10 at the subsequent estimation elapsed time to above the temperature setting values, as indicated in the fifth column from the top in the table 526. The heater controller 515 may increase the temperatures of the lateral upper heaters 9 at the subsequent estimation elapsed time from the temperature setting value.

When the current solidification rate is low, the current solid-liquid interface profile is convex upward, and the current upward convex degree is appropriate, the heater controller 515 decreases the temperatures of the upper heater 8 and the lateral lower heaters 10 at the subsequent estimation elapsed time to below the temperature setting values, as indicated in the sixth column from the top in the table 526. The heater controller 515 may decrease the temperatures of the lateral upper heaters 9 at the subsequent estimation elapsed time to below the temperature setting value.

When the current solidification rate is appropriate, the current solid-liquid interface profile is convex upward, and the current upward convex degree is too high, the heater controller 515 decreases the temperatures of the lateral lower heaters 10 at the subsequent estimation elapsed time to below the temperature setting value, as indicated in the seventh column from the top in the table 526. The heater controller 515 may decrease the temperatures of the lateral upper heaters 9 at the subsequent estimation elapsed time to below the temperature setting value.

When the current solidification rate is high, the current solid-liquid interface profile is convex upward, and the current upward convex degree is too high, the heater controller 515 increases the temperature of the upper heater 8 at the subsequent estimation elapsed time to above the temperature setting value, and decreases the temperatures of the lateral lower heaters 10 at the subsequent estimation elapsed time to below the temperature setting value, as indicated in the eighth column from the top in the table 526. The heater controller 515 may increase the temperatures of the lateral upper heaters 9 at the subsequent estimation elapsed time to above the temperature setting value.

When the current solidification rate is low, the current solid-liquid interface profile is convex upward, and the current upward convex degree is too high, the heater controller 515 decreases the temperature of each heater at the subsequent estimation elapsed time to below the temperature setting value, as indicated in the bottom column in the table 526.

The operation of the heater controller 515 performed when the current solidification ratio is higher than or equal to 70% and is lower than 90% will now be described. When the current solidification rate is appropriate and the current solid-liquid interface profile is convex downward, the heater controller 515 increases the temperatures of the lateral upper heaters 9 at the subsequent estimation elapsed time to above the temperature setting value, as indicated in the top column in the table 527.

When the current solidification rate is high and the current solid-liquid interface profile is convex downward, the heater controller 515 increases the temperatures of the upper heater 8 and the lateral upper heaters 9 at the subsequent estimation elapsed time to above the temperature setting values, as indicated in the second column from the top in the table 527.

When the current solidification rate is low and the current solid-liquid interface profile is convex downward, the heater controller 515 decreases the temperature of the upper heater 8 at the subsequent estimation elapsed time to below the temperature setting value, and increases the temperatures of the lateral upper heaters 9 at the subsequent estimation elapsed time to above the temperature setting value, as indicated in the third column from the top in the table 527. The heater controller 515 may decrease the temperatures of the lateral lower heaters 10 at the subsequent estimation elapsed time to below the temperature setting value.

When the current solidification rate is appropriate, the current solid-liquid interface profile is convex upward, and the current upward convex degree is appropriate, the heater controller 515 maintains the temperature of each heater at the subsequent estimation elapsed time to be the temperature setting value, as indicated in the fourth column from the top in the table 527.

When the current solidification rate is high, the current solid-liquid interface profile is convex upward, and the current upward convex degree is appropriate, the heater controller 515 increases the temperatures of the upper heater 8 and the lateral upper heaters 9 at the subsequent estimation elapsed time to above the temperature setting values, as indicated in the fifth column from the top in the table 527.

When the current solidification rate is low, the current solid-liquid interface profile is convex upward, and the current upward convex degree is appropriate, the heater controller 515 decreases the temperatures of the upper heater 8 and the lateral upper heaters 9 at the subsequent estimation elapsed time to below the temperature setting values, as indicated in the sixth column from the top in the table 527.

When the current solidification rate is appropriate, the current solid-liquid interface profile is convex upward, and the current upward convex degree is too high, the heater controller 515 decreases the temperatures of the lateral upper heaters 9 at the subsequent estimation elapsed time to below the temperature setting value, as indicated in the seventh column from the top in the table 527.

When the current solidification rate is high, the current solid-liquid interface profile is convex upward, and the current upward convex degree is too high, the heater controller 515 increases the temperature of the upper heater 8 at the subsequent estimation elapsed time to above the temperature setting value, and decreases the temperatures of the lateral upper heaters 9 at the subsequent estimation elapsed time to below the temperature setting value, as indicated in the eighth column from the top in the table 527.

When the current solidification rate is low, the current solid-liquid interface profile is convex upward, and the current upward convex degree is too high, the heater controller 515 decreases the temperatures of the upper heater 8 and the lateral upper heaters 9 at the subsequent estimation elapsed time to below the temperature setting values, as indicated in the bottom column in the table 527.

In the above example, the first estimator 511 can estimate the liquid phase ratio on each imaginary line L. In some embodiments, the first estimator 511 may estimate the solidification ratio on each imaginary line L. In this case, an ideal solidification ratio is prepared as training data when the parameters to be used by the first estimator 511 is learned. The solidification ratio is obtained by subtracting the liquid phase ratio from 100%.

In the above example, the solidification ratio, the solidification rate, and the interface profile information are used to control the temperatures of the upper heater 8, the lateral upper heaters 9, and the lateral lower heaters 10. In some embodiments, either the solidification rate or the interface profile information may not be used. When, for example, the solidification rate is not used, steps s21 to s24 in FIG. 12, steps s31 to s34 in FIG. 13, and steps s41 to s44 in FIG. 14 may be eliminated. When, for example, the interface profile information is not used, steps s25 to s27 in FIG. 12, steps s35 to s37 in FIG. 13, and steps s45 to s47 in FIG. 14 may be eliminated. The interface profile information may not include the upward convex degree. In this case, steps s23 and s24 in FIG. 12, step s33 and s34 in FIG. 13, and step s43 and s44 in FIG. 14 may be eliminated.

As described above, the heater controller 515 controls the temperatures of the upper heater 8, the lateral upper heaters 9, and the lateral lower heaters 10 based on at least one of the solidification rate or the interface profile information and on the solidification ratio in the solidification process. This improves the quality of the silicon ingot.

When the heater controller 515 controls the temperatures of the upper heater, the lateral upper heaters, and the lateral lower heaters based on the solidification rate, the interface profile information, and the solidification ratio in the solidification process, the quality of the silicon ingot is improved further.

In the present embodiment, the estimator 513 estimates the solidification ratio and other information based on the output power values from the upper heater 8, the lateral upper heaters 9, and the lateral lower heaters 10 and on the heat removal rate of the cooler 5 in the solidification process. The estimator 513 can appropriately estimate the solidification ratio and other information based on the output power values from the heaters and the heat removal rate of the cooler 5 that affect the solidification ratio and other information. Although the state of the casting furnace 2 changes, for example, over time and the output power values from the heaters and the heat removal rate of the cooler 5 change, each heater is controlled using the solidification ratio and other information estimated based on the output power values from the heaters and the heat removal rate of the cooler 5 to allow the resultant silicon ingot to have high quality.

The temperature of the mold 3 also affects the solidification ratio and other information. Thus, the solidification ratio and other information are estimated appropriately also based on the temperature of the mold 3.

For the control system, the manufacturing apparatus, and the control device described in detail above, the above structures are illustrative in all respects and are not limited by the disclosure. All the features of the embodiments described above may be combined in use unless any contradiction arises. Many variations not specifically described above may be implemented without departing from the scope of the disclosure.

The present disclosure provides the structures described below.
In one embodiment, (1) a control device controls temperatures of heaters included in a casting furnace. The casting furnace includes a mold to receive an inorganic material and the heaters surrounding the mold to heat the mold and cause the inorganic material to melt and solidify from a bottom to manufacture an ingot. The heaters include an upper heater located above the mold, a lateral upper heater located above and lateral to the mold, and a lateral lower heater located lateral to the mold below the lateral upper heater. The control device includes a heater controller that controls, in a solidification process of the inorganic material, a temperature of the upper heater, a temperature of the lateral upper heater, and a temperature of the lateral lower heater based on a solidification ratio of the inorganic material and at least one of a solidification rate of the inorganic material or interface profile information indicating a solid-liquid interface profile of the inorganic material.
(2) In the control device according to (1), the heater controller controls, in the solidification process, the temperature of the upper heater, the temperature of the lateral upper heater, and the temperature of the lateral lower heater based on the solidification rate, the interface profile information, and the solidification ratio.
(3) In the control device according to (1) or (2), the heater controller controls, in the solidification process, the upper heater, the lateral upper heater, and the lateral lower heater based on a temperature profile indicating a temperature setting value of the upper heater, a temperature setting value of the lateral upper heater, and a temperature setting value of the lateral lower heater at an elapsed time. The interface profile information includes convex information indicating whether the solid-liquid interface profile is convex downward. The heater controller increases the temperature of the lateral lower heater to above the temperature setting value of the lateral lower heater when the solidification ratio is lower than a threshold for a first solidification ratio and the solid-liquid interface profile is convex downward.
(4) In the control device according to (3), the heater controller increases at least the temperature of the lateral lower heater, of the temperature of the lateral upper heater and the temperature of the lateral lower heater, to above the temperature setting value of the lateral lower heater or the temperature setting value of the lateral upper heater when the solidification rate is higher than the threshold for the first solidification ratio and is lower than a threshold for a second solidification ratio higher than the threshold for the first solidification ratio and the solid-liquid interface profile is convex downward.
(5) In the control device according to (4), the heater controller increases the temperature of the lateral upper heater to above the temperature setting value of the lateral upper heater when the solidification rate is higher than the threshold for the second solidification ratio and the solid-liquid interface profile is convex downward.
(6) In the control device according to (1) or (2), the heater controller controls, in the solidification process, the upper heater, the lateral upper heater, and the lateral lower heater based on a temperature profile indicating a temperature setting value of the upper heater, a temperature setting value of the lateral upper heater, and a temperature setting value of the lateral lower heater at an elapsed time. The interface profile information includes convex information indicating whether the solid-liquid interface profile is convex upward, and an upward convex degree of the solid-liquid interface profile. The heater controller decreases the temperature of the lateral lower heater to below the temperature setting value of the lateral lower heater when the solidification ratio is lower than a threshold for a first solidification ratio, the solid-liquid interface profile is convex upward, and the upward convex degree is higher than a predetermined range.
(7) In the control device according to (6), the heater controller decreases at least the temperature of the lateral lower heater, of the temperature of the lateral upper heater and the temperature of the lateral lower heater, to below the temperature setting value of the lateral lower heater or the temperature setting value of the lateral upper heater when the solidification ratio is higher than the threshold for the first solidification ratio and is lower than a threshold for a second solidification ratio higher than the threshold for the first solidification ratio, the solid-liquid interface profile is convex upward, and the upward convex degree is higher than the predetermined range.
(8) In the control device according to (7), the heater controller decreases the temperature of the lateral upper heater to below the temperature setting value of the lateral upper heater when the solidification ratio is higher than the threshold for the second solidification ratio, the solid-liquid interface profile is convex upward, and the upward convex degree is higher than the predetermined range.
(9) In the control device according to any one of (1) to (8), the heater controller controls, in the solidification process, the upper heater, the lateral upper heater, and the lateral lower heater based on a temperature profile indicating a temperature setting value of the upper heater, a temperature setting value of the lateral upper heater, and a temperature setting value of the lateral lower heater at an elapsed time. The heater controller decreases the temperature of the upper heater to below the temperature setting value of the upper heater when the solidification rate is lower than a predetermined rate range.
(10) In the control device according to (9), the heater controller increases the temperature of the upper heater to above the temperature setting value of the upper heater when the solidification rate is higher than the predetermined rate range.
(11) In the control device according to any one of (1) to (10), the casting furnace includes a cooler to cool the mold in the solidification process. The control device further comprises an estimator that estimates, in the solidification process, the solidification ratio and at least one of the solidification rate or the interface profile information based on an output power value from the upper heater, an output power value from the lateral upper heater, an output power value from the lateral lower heater, and a heat removal rate of the cooler.
(12) In the control device according to (11), the estimator estimates, in the solidification process, the solidification ratio and at least one of the solidification rate or the interface profile information based on the output power value from the upper heater, the output power value from the lateral upper heater, the output power value from the lateral lower heater, the heat removal rate of the cooler, and a temperature of the mold.
(13) A manufacturing system includes a casting furnace including a mold to receive an inorganic material and heaters surrounding the mold to heat the mold and cause the inorganic material to melt and solidify from a bottom to manufacture an ingot, and the control device according to any one of (1) to (12) that controls temperatures of the heaters included in the casting furnace.

### Reference Signs List

- 2: casting furnace
- 3: mold
- 5: cooler
- 7: heater
- 8: upper heater
- 9: lateral upper heater
- 10: lateral lower heater
- 200: inorganic material
- 500: control device
- 513: estimator
- 515: heater controller
- 1000: manufacturing system

## Claims

1. A control device for controlling temperatures of heaters included in a casting furnace, the casting furnace including a mold to receive an inorganic material and the heaters surrounding the mold to heat the mold and cause the inorganic material to melt and solidify from a bottom to manufacture an ingot, the heaters including an upper heater located above the mold, a lateral upper heater located above and lateral to the mold, and a lateral lower heater located lateral to the mold below the lateral upper heater,
the control device comprising:
a heater controller configured to control, in a solidification process of the inorganic material, a temperature of the upper heater, a temperature of the lateral upper heater, and a temperature of the lateral lower heater based on a solidification ratio of the inorganic material and at least one of a solidification rate of the inorganic material or interface profile information indicating a solid-liquid interface profile of the inorganic material.

2. The control device according to claim 1, wherein
the heater controller controls, in the solidification process, the temperature of the upper heater, the temperature of the lateral upper heater, and the temperature of the lateral lower heater based on the solidification rate, the interface profile information, and the solidification ratio.

3. The control device according to claim 1 or claim 2, wherein
the heater controller controls, in the solidification process, the upper heater, the lateral upper heater, and the lateral lower heater based on a temperature profile indicating a temperature setting value of the upper heater, a temperature setting value of the lateral upper heater, and a temperature setting value of the lateral lower heater at an elapsed time,
the interface profile information includes convex information indicating whether the solid-liquid interface profile is convex downward, and
the heater controller increases the temperature of the lateral lower heater to above the temperature setting value of the lateral lower heater when the solidification ratio is lower than a threshold for a first solidification ratio and the solid-liquid interface profile is convex downward.

4. The control device according to claim 3, wherein
the heater controller increases at least the temperature of the lateral lower heater, of the temperature of the lateral upper heater and the temperature of the lateral lower heater, to above the temperature setting value of the lateral lower heater or the temperature setting value of the lateral upper heater when the solidification rate is higher than the threshold for the first solidification ratio and is lower than a threshold for a second solidification ratio higher than the threshold for the first solidification ratio and the solid-liquid interface profile is convex downward.

5. The control device according to claim 4, wherein
the heater controller increases the temperature of the lateral upper heater to above the temperature setting value of the lateral upper heater when the solidification rate is higher than the threshold for the second solidification ratio and the solid-liquid interface profile is convex downward.

6. The control device according to claim 1 or claim 2, wherein
the heater controller controls, in the solidification process, the upper heater, the lateral upper heater, and the lateral lower heater based on a temperature profile indicating a temperature setting value of the upper heater, a temperature setting value of the lateral upper heater, and a temperature setting value of the lateral lower heater at an elapsed time,
the interface profile information includes convex information indicating whether the solid-liquid interface profile is convex upward, and an upward convex degree of the solid-liquid interface profile, and
the heater controller decreases the temperature of the lateral lower heater to below the temperature setting value of the lateral lower heater when the solidification ratio is lower than a threshold for a first solidification ratio, the solid-liquid interface profile is convex upward, and the upward convex degree is higher than a predetermined range.

7. The control device according to claim 6, wherein
the heater controller decreases at least the temperature of the lateral lower heater, of the temperature of the lateral upper heater and the temperature of the lateral lower heater, to below the temperature setting value of the lateral lower heater or the temperature setting value of the lateral upper heater when the solidification ratio is higher than the threshold for the first solidification ratio and is lower than a threshold for a second solidification ratio higher than the threshold for the first solidification ratio, the solid-liquid interface profile is convex upward, and the upward convex degree is higher than the predetermined range.

8. The control device according to claim 7, wherein
the heater controller decreases the temperature of the lateral upper heater to below the temperature setting value of the lateral upper heater when the solidification ratio is higher than the threshold for the second solidification ratio, the solid-liquid interface profile is convex upward, and the upward convex degree is higher than the predetermined range.

9. The control device according to any one of claims 1 to 8, wherein
the heater controller controls, in the solidification process, the upper heater, the lateral upper heater, and the lateral lower heater based on a temperature profile indicating a temperature setting value of the upper heater, a temperature setting value of the lateral upper heater, and a temperature setting value of the lateral lower heater at an elapsed time, and
the heater controller decreases the temperature of the upper heater to below the temperature setting value of the upper heater when the solidification rate is lower than a predetermined rate range.

10. The control device according to claim 9, wherein
the heater controller increases the temperature of the upper heater to above the temperature setting value of the upper heater when the solidification rate is higher than the predetermined rate range.

11. The control device according to any one of claims 1 to 10, wherein
the casting furnace includes a cooler to cool the mold in the solidification process, and
the control device further comprises an estimator configured to estimate, in the solidification process, the solidification ratio and at least one of the solidification rate or the interface profile information based on an output power value from the upper heater, an output power value from the lateral upper heater, an output power value from the lateral lower heater, and a heat removal rate of the cooler.

12. The control device according to claim 11, wherein
the estimator estimates, in the solidification process, the solidification ratio and at least one of the solidification rate or the interface profile information based on the output power value from the upper heater, the output power value from the lateral upper heater, the output power value from the lateral lower heater, the heat removal rate of the cooler, and a temperature of the mold.

13. A manufacturing system, comprising:
a casting furnace including a mold to receive an inorganic material and heaters surrounding the mold to heat the mold and cause the inorganic material to melt and solidify from a bottom to manufacture an ingot; and
the control device according to any one of claims 1 to 12 configured to control temperatures of the heaters included in the casting furnace.
